# EUROPÄISCHE PATENTSCHRIFT

(11) **EP 3 372 052 B1**
(45) Veröffentlichungstag und Bekanntmachung des Hinweises auf die Patenterteilung: **09.09.2020**
(21) Anmeldenummer: 16791410.0
(22) Anmeldetag: 07.11.2016
(51) Int. Cl.: H05B 3/86, H03K 17/96

(54) **SCHEIBENANORDNUNG MIT BEHEIZBARER VERBUNDSCHEIBE MIT KAPAZITIVEM SCHALTBEREICH**
HEATABLE COMPOUND GLAZING WITH CAPACITIVE SWITCHING RANGE
VITRE COMPOSITE POUVANT ÊTRE CHAUFFÉE PRÉSENTANT UNE ZONE DE COMMUTATION CAPACITIVE

(30) Priorität: 06.11.2015 EP 15193393
(43) Veröffentlichungstag der Anmeldung: 12.09.2018
(73) Patentinhaber: SAINT-GOBAIN GLASS FRANCE, 92400 Courbevoie (FR)
(72) Erfinder: KLEIN, Marcel, 52499 Baesweiler (DE); DROSTE, Stefan, 52134 Herzogenrath (DE); WEBER, Patrick, 52477 Alsdorf (DE)
(74) Vertreter: Gebauer, Dieter Edmund
(86) Internationale Anmeldenummer: PCT/EP2016/076891
(87) Internationale Veröffentlichungsnummer: WO 2017/077133

(56) Entgegenhaltungen:
- WO-A1-2015/162107
- WO-A1-2015/162108
- US-A1- 2007 194 216
- US-A1- 2010 179 725
- US-A1- 2013 075 383

## Beschreibung

Die Erfindung betrifft eine Scheibenanordnung mit einer beheizbaren Verbundscheibe mit kapazitivem Schaltbereich, ein Verfahren zu deren Herstellung und deren Verwendung.

Verbundscheiben umfassen typischerweise zwei Scheiben, beispielsweise eine Außenscheibe und eine Innenscheibe, die über eine Zwischenschicht, beispielsweise aus einer thermoplastischen Polyvinylbutyral (PVB)-Folie, miteinander verbunden sind. Elektrisch beheizbare Verbundscheiben sind beispielsweise mit Heizdrähten ausgestattet und werden in der Fahrzeugtechnik häufig eingesetzt, beispielsweise als Seitenscheibe, wie aus DE10126869A1 oder WO2005055667A2 bekannt ist. Die Heizdrähte sind in der Oberfläche der thermoplastischen Zwischenschicht eingebettet. Zur elektrischen Kontaktierung der Heizdrähte sind typischerweise Stromsammelschienen vorgesehen. Geeignete Stromsammelschienen sind beispielsweise Streifen einer Kupferfolie, welche mit einer externen Spannungsquelle verbunden werden. Die Heizdrähte verlaufen zwischen den Stromsammelschienen, so dass nach Anlegen einer elektrischen Spannung ein elektrischer Strom durch die Heizdrähte fließen kann, wodurch die Heizwirkung erreicht wird.

Es ist bekannt, dass Schaltbereiche durch eine Flächenelektrode oder durch eine Anordnung von zwei gekoppelten Elektroden ausgebildet werden können, beispielsweise als kapazitive Schaltbereiche. Nähert sich ein Objekt dem Schaltbereich an, so ändert sich die Kapazität der Flächenelektrode gegen Erde oder die Kapazität des von den zwei gekoppelten Elektroden gebildeten Kondensators. Die Kapazitätsänderung wird über eine Schaltungsanordnung oder Sensorelektronik gemessen und bei Überschreiten eines Schwellwerts wird ein Schaltsignal ausgelöst. Schaltungsanordnungen für kapazitive Schalter sind beispielsweise aus DE 20 2006 006 192 U1,

EP 0 899 882 A1, US 6,452,514 B1 und EP 1 515 211 A1 bekannt. Die Dokumenten WO 2015/162107 A1 und Wo 2015/162108 A1 offenbaren weitere Scheibenanordnungen mit kapazitivem Schaltbereich nach dem Stand der Technik.

Die Aufgabe der vorliegenden Erfindung besteht darin, eine verbesserte beheizbare Verbundscheibe bereitzustellen, die einen kapazitiven Schaltbereich aufweist, der einfach und kostengünstig in die Verbundscheibe integriert werden kann und der die Durchsicht durch Scheibe nicht oder nur wenig behindert. Mit dem kapazitiven Schaltbereich kann in einfacher Weise ein Berührungssensor gebildet werden. Die Aufgabe der vorliegenden Erfindung wird erfindungsgemäß durch eine Scheibenanordnung mit einer beheizbaren Verbundscheibe mit kapazitivem Schaltbereich gemäß dem unabhängigen Anspruch 1 gelöst. Bevorzugte Ausführungen gehen aus den Unteransprüchen hervor.

Die Verbundscheibe ist bevorzugt eine Fahrzeugscheibe wie eine Seitenscheibe, eine Windschutzscheibe, eine Heckscheibe oder eine Dachscheibe. Die Verbundscheibe kann aber auch eine Architekturscheibe oder eine Verglasung in einem Möbel, beispielsweise einem Kühlschrank, einem Gefrierschrank oder einem elektrischen Heizkörper oder Spiegelelement sein.

Die Verbundscheibe ist bevorzugt eine Seitenscheibe für ein öffenbares Seitenfenster eines Fahrzeugs. Darunter wird ein Seitenfenster verstanden, welches sich durch im Wesentlichen vertikale Verschiebung der Seitenscheibe in die Karosserietür hinein öffnen und wieder schließen lässt.

Die Verbundscheibe und insbesondere die Seitenscheibe weist eine Oberkante, einer Unterkante, einer Vorderkante und einer Hinterkante auf. Im Falle einer Seitenscheibe wird mit Oberkante die Seitenkante der Seitenscheibe bezeichnet, welche in Einbaulage nach oben weist. Mit Unterkante wird die Seitenkante bezeichnet, welche in Einbaulage nach unten zum Erdboden weist. Mit Vorderkante wird die Seitenkante bezeichnet, welche in Fahrtrichtung nach vorne gerichtet ist. Mit Hinterkante wird die Seitenkante bezeichnet, welche in Fahrtrichtung nach hinten gerichtet ist.

In der Scheibenanordnung umfasst die erfindungsgemäße Verbundscheibe mit kapazitivem Schaltbereich zumindest die folgenden Merkmale:
- ein Substrat und eine Deckscheibe sowie
- mindestens eine erste Zwischenschicht, die flächig zwischen dem Substrat und der Deckscheibe angeordnet ist,
wobei
- zwischen dem Substrat und der ersten Zwischenschicht oder zwischen der Deckscheibe und der ersten Zwischenschicht zumindest abschnittsweise eine Trägerfolie mit einer elektrisch leitfähigen Schicht angeordnet ist,
- mindestens ein Bereich der elektrisch leitfähigen Schicht einen kapazitiven Schaltbereich bildet,
- der kapazitive Schaltbereich einen Berührungsbereich, einen Zuleitungsbereich und einen Anschlussbereich aufweist, der Zuleitungsbereich den Berührungsbereich mit dem Anschlussbereich elektrisch verbindet und der Anschlussbereich mit einer Sensorelektronik elektrisch verbindbar ist und
- mindestens ein Heizdraht und mindestens zwei Stromsammelleiter zwischen dem Substrat und der Deckscheibe angeordnet sind, wobei jeweils ein Ende des Heizdrahts mit jeweils einem der Sammelleiter elektrisch leitend verbunden ist, so dass bei Anlegen einer elektrischen Spannung an die Sammelleiter ein Heizstrom durch den Heizdraht fließen kann, wodurch der Heizdraht beheizbar ist.

Durch die Beheizbarkeit des Heizdrahts ist die Verbundscheibe beheizbar.

Bei einer vorteilhaften Ausgestaltung der Erfindung ist der zweite Eingang der Sensorelektronik mit einer elektrischen Masse verbunden.

Bei einer vorteilhaften Ausgestaltung der Erfindung überlappt der kapazitive Schaltbereich in Projektion durch die Verbundscheibe mit mindestens einem Heizdraht.

In einer vorteilhaften Ausgestaltung der Erfindung beträgt das Verhältnis von Länge l_{Z} zu Breite b_{Z} des Zuleitungsbereichs kleiner oder gleich 1:700 und bevorzugt von 1:1 bis 1:100. Weist der Zuleitungsbereich keine konstante Breite b_{Z} auf, beispielsweise wenn er trapezförmig oder tropfenförmig ausgebildet ist, so wird im Rahmen der vorliegenden Erfindung unter der Breite b_{Z} die gemittelte Breite des Zuleitungsbereichs verstanden.

Die Länge l_{Z} des Zuleitungsbereichs beträgt bevorzugt von 1 cm bis 70 cm und besonders bevorzugt von 3 cm bis 8 cm. Die Breite b_{Z} des Zuleitungsbereichs beträgt bevorzugt von 0,5 mm bis 10 mm und besonders bevorzugt von 0,5 mm bis 2 mm. Die Form des Zuleitungsbereichs ist bevorzugt rechteckförmig, streifenförmig oder linienförmig.

In einer vorteilhaften Ausgestaltung der erfindungsgemäßen Verbundscheibe ist der Anschlussbereich am äußeren Rand der Scheibe angeordnet. Dabei beträgt der Abstand zum äußeren Rand bevorzugt weniger als 10 cm, besonders bevorzugt weniger als 0,5 cm. Dies erlaubt es eine elektrische Kontaktierung des Anschlussbereichs, beispielsweise mit einem Folienleiter, unter einem optisch unauffälligen Schwarzdruck oder mit einer Abdeckung, beispielsweise einem Kameragehäuse zu kaschieren.

In einer vorteilhaften Ausgestaltung des erfindungsgemäßen Schaltbereichs hat der Berührungsbereich eine Fläche von 1 cm² bis 200 cm², besonders bevorzugt von 1 cm² bis 9 cm². Die Länge l_{B} des Berührungsbereichs beträgt bevorzugt von von 1 cm bis 14 cm und besonders bevorzugt von 1 cm bis 3 cm. Die maximale Breite b_{B} des Berührungsbereichs beträgt bevorzugt von 1 cm bis 14 cm und besonders bevorzugt von 1 cm bis 3 cm. Der Berührungsbereich kann prinzipiell jede beliebige Form aufweisen. Besonders geeignete Berührungsbereiche sind kreisförmig, elliptisch oder tropfenförmig ausgebildet. Alternativ sind eckige Formen möglich, beispielsweise Dreiecke, Quadrate, Rechtecke, Trapeze oder anders geartete Vierecke oder Polygone höherer Ordnung.

In einer weiteren vorteilhaften Ausgestaltung des erfindungsgemäßen Schaltbereichs beträgt das Verhältnis der Breite b_{Z} des Zuleitungsbereichs zur maximalen Breite b_{B} des Berührungsbereichs von mindestens 1:2 und insbesondere von mindestens 1:10. Dadurch konnten besonders gute Schaltergebnisse erzielt werden.

In einer vorteilhaften Ausgestaltung der erfindungsgemäßen Scheibe, beträgt die Breite t₁ der Trennlinien von 30 µm bis 200 µm und bevorzugt von 70 µm bis 140 µm. Derartig dünne Trennlinien erlauben eine sichere und ausreichend hohe elektrische Isolierung und stören gleichzeitig die Durchsicht durch die Verbundscheibe nicht oder nur geringfügig.

Der Schaltbereich ist ein kapazitiver Schaltbereich, das heißt, er ist besonders für eine kapazitive Berührungsdetektion ausgebildet. In einer vorteilhaften Ausgestaltung bildet der Schaltbereich dabei eine Flächenelektrode aus. Über eine externe kapazitive Sensorelektronik wird die Kapazität der Flächenelektrode gemessen. Die Kapazität der Flächenelektrode ändert sich gegen Erde, wenn ein Körper (insbesondere ein menschlicher Körper oder ein Körper mit einer ähnlichen Dielektrizitätskontanten wie ein menschlicher Körper), in ihre Nähe kommt oder beispielsweise eine Isolatorschicht über der Flächenelektrode berührt. Die Isolatorschicht umfasst insbesondere das Substrat selbst. Die Kapazitätsänderung wird durch die Sensorelektronik gemessen und bei Überschreiten eines Schwellwerts wird ein Schaltsignal ausgelöst. Der Schaltbereich wird durch Form und Größe der Flächenelektrode festgelegt.

Neben der soeben dargestellten Kapazitätsmessung gegenüber Erde, kann auch eine differenzielle Kapazitätsmessung zwischen der der elektrisch leitfähigen Schicht und einem weiteren elektrisch leitfähigen Bereich gemessen werden.

In einer Alternative der erfindungsgemäßen Verbundscheibe, welche nicht Teil der Erfindung ist, ist die elektrisch leitfähige Schicht durch mindestens eine beschichtungsfreie Trennlinie in den kapazitiven Schaltbereich und einen Umgebungsbereich elektrisch unterteilt. Der Umgebungsbereich ist über einen weiteren Anschlussbereich mit der Sensorelektronik verbindbar. Das heißt, die Verbundscheibe wird mit vier Zuleitungen kontaktiert: eine Zuleitung für den kapazitiven Schaltbereich, eine Zuleitung für den Umgebungsbereich und zwei Zuleitungen für die Stromsammelleiter zur elektrischen Beheizung durch den Heizdraht.

In einer solchen Anordnung bilden der kapazitive Schaltbereich und der Umgebungsbereich zwei Elektroden aus, die kapazitiv miteinander gekoppelt sind. Die Kapazität des von den Elektroden gebildeten Kondensators ändert sich bei Annäherung eines Körpers, beispielsweise eines menschlichen Körperteils. Die Kapazitätsänderung wird durch eine Sensorelektronik gemessen und bei Überschreiten eines Schwellwerts wird ein Schaltsignal ausgelöst. Der sensitive Bereich wird durch Form und Größe des Bereichs, in denen die Elektroden kapazitiv gekoppelt sind, festgelegt.

Erfindungsgemäß ist der Heizschaltkreis, also der Schaltkreis aus Heizdraht und Stromsammelleiter, als zweite Elektrode mit der Sensorelektronik verbunden. Das heißt, der Heizdraht und die Stromsammelleiter funktionieren als Umgebungsbereich. Die ist besonders vorteilhaft, da die elektrische Verbindung dieser zweiten Elektrode zur Sensorelektronik auch außerhalb der Verbundscheibe erfolgen kann, beispielsweise im Bereich einer der Zuleitungen, mit denen die Stromsammelleiter mit der Betriebsspannung für die Heizfunktion verbunden sind, insbesondere mit der Masseleitung. Dadurch entfällt eine getrennte Zuleitung zum Umgebungsbereich und die gesamte Verbundscheibe wird nur noch mit drei Zuleitungen kontaktiert: eine Zuleitung für den kapazitiven Schaltbereich und zwei Zuleitungen für die Stromsammelleiter, wobei eine der Zuleitungen für die Stromsammelleiter als elektrische Leitungsverbindung zum zweiten Eingang der Sensorelektronik dient.

Der kapazitive Schaltbereich und gegebenenfalls der Umgebungsbereich bzw. der Heizschaltkreis sind in die erfindungsgemäße Verbundscheibe integriert. Es ist also kein Schalter oder ähnliches als separates Bauteil nötig, welches an der Verbundscheibe angebracht werden muss. Die Verbundscheibe weist bevorzugt auch keine sonstigen Bauteile auf, die im Durchsichtbereich auf ihren Oberflächen angeordnet sind. Das ist besonders vorteilhaft im Hinblick auf eine dünne Bauweise der Verbundscheibe sowie einer nur geringen Störung der Durchsicht durch die Verbundscheibe.

Die erfindungsgemäße Scheibenanordnung umfasst eine erfindungsgemäße Verbundscheibe und eine Sensorelektronik, die über den Anschlussbereich mit dem kapazitiven Schaltbereich und gegebenenfalls über einen weiteren Anschlussbereich mit der Umgebungsfläche oder dem Heizschaltkreis elektrisch verbunden ist. Die Sensorelektronik ist eine kapazitive Sensorelektronik.

In einer vorteilhaften Ausgestaltung der erfindungsgemäßen Schaltanordnung ist die Empfindlichkeit der Sensorelektronik so gewählt, dass die Sensorelektronik bei Berührung des Berührungsbereichs mit einem menschlichen Finger auf dem Substrat ein Schaltsignal ausgibt und bei Berührung des Berührungsbereichs auf der Deckscheibe kein Schaltsignal oder ein anderes Schaltsignal ausgibt. Es versteht sich, dass die Berührung des Berührungsbereichs auch mit mehreren Fingern oder einem anderen menschlichen Körperteil erfolgen kann. Unter Berührung wird im Rahmen dieser Erfindung jegliche Wechselwirkung mit dem Schaltbereich verstanden, die zu einer messbaren Änderung des Messsignals, also hier der Kapazität, führt. Insbesondere ist dies eine Berührung einer außenseitigen Oberfläche der Verbundscheibe in einer Zone, die sich durch orthogonale Projektion des Berührungsbereichs auf der außenseitigen Oberfläche ergibt.

In einer vorteilhaften Ausgestaltung der Erfindung ist der Flächenkapazitätsbelag c_{I} zwischen dem Berührungsbereich und der außenseitigen Oberfläche (IV) des Substrats größer als der Flächenkapazitätsbelag c_{A} zwischen dem Berührungsbereich und der außenseitigen Oberfläche (I) der Deckscheibe.

Der Flächenkapazitätsbelag c_{I} beziehungsweise c_{A} ist definiert als die Kapazität eines Plattenkondensators desjenigen Bereichs der Verbundscheibe, der sich durch orthogonale Projektion des Berührungsbereichs zwischen dem Berührungsbereich und der außenseitigen Oberfläche des Substrats beziehungsweise der außenseitigen Oberfläche der Deckscheibe ergibt, wobei die sich ergebende Kapazität auf die Fläche des Berührungsbereichs normiert wird. Außenseitige Oberfläche bedeutet hierbei die Oberfläche der Verbundscheibe die nach außen, also von der Verbundscheibe weg weißt. Innenseitige Oberfläche bedeutet demnach die Oberfläche des Substrats oder der Deckscheibe, die ins Innere der Verbundscheibe weist und mit einer Zwischenschicht flächig verbunden ist.

Der Flächenkapazitätsbelag ist folglich die auf die Fläche normierte Kapazität der gesamten Schichtfolgen (Belag) von der elektrisch leitfähigen Schicht bis zur jeweiligen außenseitigen Oberfläche der Verbundscheibe.

In einer vorteilhaften Ausgestaltung der erfindungsgemäßen Verbundscheibe ist das Verhältnis des Flächenkapazitätsbelags c_{I} zum Flächenkapazitätsbelag c_{A} größer oder gleich 1,1:1, bevorzugt größer oder gleich 1,2:1. Für derartige Verhältnisse lässt sich eine Berührung der außenseitigen Oberfläche des Substrats bereits gut von einer Berührung der außenseitigen Oberfläche der Deckscheibe unterscheiden.

Die ausgegebenen Schaltsignale können beliebig und den Erfordernissen der jeweiligen Verwendung angepasst sein. So kann das Schaltsignal eine positive Spannung, beispielsweise 12 V, bedeuten, kein Schaltsignal beispielsweise 0 V bedeuten und ein anderes Schaltsignal beispielweise + 6 bedeuten. Die Schaltsignale können auch den bei einem CAN-Bus üblichen Spannungen CAN_High und CAN_Low entsprechen und um einen dazwischen liegenden Spannungswert wechseln. Das Schaltsignal kann auch gepulst und/oder digital codiert sein.

Die Empfindlichkeit der Sensorelektronik kann in Abhängigkeit der Größe des Berührungsbereichs und in Abhängigkeit der Dicke von Substrat, Zwischenschichten und Deckscheibe im Rahmen einfacher Experimente ermittelt werden.

Der besondere Vorteil einer solchen erfindungsgemäßen Scheibenanordnung liegt darin, dass das Schaltsignal nur bei Berührung der Verbundscheibe von einer der außenseitigen Oberflächen ausgelöst werden kann. Bei einer Verwendung der Scheibenanordnung in einer Fahrzeugscheibe und Einbau der Verbundscheibe mit der Substratseite in Richtung des Fahrzeuginnenraums, kann beispielsweise ein Auslösen des Schaltvorgangs durch Personen von außen oder ein ungewolltes Auslösen des Schaltvorgangs durch Regen oder die Bewegung des Scheibenwischers sicher vermieden werden, ohne den generell üblichen Scheibenaufbau für Verbundsicherheitsglas grundlegend zu verändern. Dies war für den Fachmann unerwartet und überraschend.

In Kombination mit der soeben beschriebenen Scheibenanordnung oder alternativ dazu, kann die Empfindlichkeit der Sensorelektronik so gewählt werden, dass sie bei Berührung des Berührungsbereichs auf dem Substrat und/oder der Deckscheibe mit einem menschlichen Finger ein Schaltsignal ausgibt und bei Berührung des Zuleitungsbereichs auf dem Substrat und/oder der Deckscheibe kein Schaltsignal oder ein anderes Schaltsignal ausgibt.

Die Empfindlichkeit der Sensorelektronik kann in Abhängigkeit der Größe des Berührungsbereichs und in Abhängigkeit der Geometrie sowie des Aspektverhältnisses zwischen Breite und Länge des Zuleitungsbereichs im Rahmen einfacher Experimente ermittelt werden. Besonders vorteilhaft ist es dabei, wenn die Breite des Zuleitungsbereichs möglichst gering gewählt wird.

Der besondere Vorteil dieser Ausführungsform einer erfindungsgemäßen Scheibenanordnung liegt darin, dass das Schaltsignal nur bei Berührung der außenseitigen Oberfläche der Verbundscheibe über dem Berührungsbereich oder seiner unmittelbaren Umgebung ausgelöst werden kann und so eine präzise Steuerung des Schaltvorgangs möglich ist und beispielsweise ein versehentliches Schalten vermieden wird.

In einer vorteilhaften Weiterbildung einer erfindungsgemäßen Scheibenanordnung ist der Anschlussbereich mit einem Flachleiter verbunden und der Flachleiter ist aus der Scheibe herausgeführt. Die integrierte Scheibenanordnung kann dann besonders einfach am Verwendungsort mit einer Spannungsquelle und einer Signalleitung verbunden werden, die das Schaltsignal der Sensorschaltung auswertet, beispielsweise in einem Fahrzeug über einen CAN-Bus.

Als Substrat und Deckscheibe sind im Grunde alle elektrisch isolierenden Substrate geeignet, die unter den Bedingungen der Herstellung und der Verwendung der erfindungsgemäßen Verbundscheibe thermisch und chemisch stabil sowie dimensionsstabil sind.

Das Substrat und/oder die Deckscheibe enthalten bevorzugt Glas, besonders bevorzugt Flachglas, Floatglas, Quarzglas, Borosilikatglas, Kalk-Natron-Glas, oder klare Kunststoffe, vorzugsweise starre klare Kunststoffe, insbesondere Polyethylen, Polypropylen, Polycarbonat, Polymethylmethacrylat, Polystyrol, Polyamid, Polyester, Polyvinylchlorid und/oder Gemische davon. Das Substrat und/oder die Deckscheibe sind bevorzugt transparent, insbesondere für die Verwendung der Scheibe als Windschutzscheibe oder Rückscheibe eines Fahrzeugs oder anderen Verwendungen bei denen eine hohe Lichttransmission erwünscht ist. Als transparent im Sinne der Erfindung wird dann eine Scheibe verstanden, die eine Transmission im sichtbaren Spektralbereich von größer als 70 % aufweist. Für Scheiben, die nicht im verkehrrelevanten Sichtfeld des Fahrers liegen, beispielsweise für Dachscheiben, kann die Transmission aber auch viel geringer sein, beispielsweise größer als 5 %.

Die Dicke von Substrat und/oder Deckscheibe kann breit variieren und so hervorragend den Erfordernissen des Einzelfalls angepasst werden. Vorzugsweise werden Standardstärken von 1,0 mm bis 25 mm, bevorzugt von 1,4 mm bis 2,5 mm für Fahrzeugglas und bevorzugt von 4 mm bis 25 mm für Möbel, Geräte und Gebäude, insbesondere für elektrische Heizkörper, verwendet. Die Größe der Scheibe kann breit variieren und richtet sich nach der Größe der erfindungsgemäßen Verwendung. Das Substrat und gegebenenfalls die Deckscheibe weisen beispielsweise im Fahrzeugbau und Architekturbereich übliche Flächen von 200 cm² bis zu 20 m² auf.

Die Verbundscheibe kann eine beliebige dreidimensionale Form aufweisen. Vorzugsweise hat die dreidimensionale Form keine Schattenzonen, so dass sie beispielsweise durch Kathodenzerstäubung beschichtet werden kann. Bevorzugt sind die Substrate planar oder leicht oder stark in einer Richtung oder in mehreren Richtungen des Raumes gebogen. Insbesondere werden planare Substrate verwendet. Die Scheiben können farblos oder gefärbt sein.

Das Substrat und/oder die Deckscheibe weisen bevorzugt eine relative Permittivität ε_{r,1/4} von 2 bis 8 und besonders bevorzugt von 6 bis 8 auf. Bei derartigen relativen Permittivitäten konnte eine besonders gute Unterscheidung zwischen einer Berührung der Berührungsfläche über die außenseitige Oberfläche des Substrats von gegenüber der außenseitigen Oberfläche der Deckscheibe erzielt werden.

Substrate und/oder Deckscheiben werden durch mindestens eine erste und eine zweite Zwischenschicht miteinander verbunden. Die Zwischenschicht ist bevorzugt transparent. Die Zwischenschicht enthält vorzugsweise mindestens einen Kunststoff, bevorzugt Polyvinylbutyral (PVB), Ethylenvinylacetat (EVA) und/oder Polyethylenterephthalat (PET). Die Zwischenschicht kann aber auch beispielsweise Polyurethan (PU), Polypropylen (PP), Polyacrylat, Polyethylen (PE), Polycarbonat (PC), Polymethylmetacrylat, Polyvinylchlorid, Polyacetatharz, Gießharze, Acrylate, fluorinierte Ethylen-Propylene, Polyvinylfluorid und/oder Ethylen-Tetrafluorethylen, oder Copolymere oder Gemische davon enthalten. Die Zwischenschicht kann durch eine oder auch durch mehrere übereinander angeordnete Folien ausgebildet werden, wobei die Dicke einer Folie bevorzugt von 0,025 mm bis 1 mm beträgt, typischerweise 0,38 mm oder 0,76 mm. Das heißt die erste oder die zweite Zwischenschicht können jeweils aus einer oder aus mehreren Folien aufgebaut sein. Die Zwischenschichten können bevorzugt thermoplastisch sein und nach der Lamination das Substrat, die Deckscheibe und eventuelle weitere Zwischenschichten miteinander verkleben. In einer besonders vorteilhaften Ausgestaltung der erfindungsgemäßen Verbundscheibe ist die erste Zwischenschicht als Klebeschicht aus einem Klebstoff ausgebildet, mit der die Trägerfolie auf dem Substrat aufgeklebt ist. In diesem Fall hat die erste Zwischenschicht bevorzugt die Abmessungen der Trägerfolie.

Die Zwischenschicht hat bevorzugt eine relative Permittivität von 2 bis 4 und besonders bevorzugt von 2,1 bis 2,9. Bei derartigen relativen Permittivitäten konnte eine besonders gute Unterscheidung zwischen einer Berührung der Berührungsfläche über die außenseitige Oberfläche des Substrats von gegenüber der außenseitigen Oberfläche der Deckscheibe erzielt werden.

Die erfindungsgemäße Trägerfolie ist bevorzugt transparent. Sie enthält bevorzugt eine Polyethylenterepthalat (PET)-Folie oder besteht daraus. Die Dicke der Trägerfolie beträgt bevorzugt von 0,025 mm bis 0,1 mm. Die Trägerfolie hat bevorzugt eine relative Permittivität von 2 bis 4 und besonders bevorzugt von 2,7 bis 3,3. Mit derartigen Trägerfolien lassen sich besonders gute Verbundscheiben herstellen, da derart dünne Trägerfolien auch bei nur abschnittsweiser Anordnung gut und optisch unauffällig in der Verbundscheibe integrierbar sind. Gleichzeit lassen sich gute und selektive Schaltsignale erzeugen. Die erfindungsgemäße elektrisch leitfähige Schicht ist bevorzugt auf einer Oberfläche der Trägerfolie angeordnet, das heißt auf genau einer der beiden Seiten der Trägerfolie (also auf deren Vorderseite oder deren Rückseite).

Die Begriffe "Substrat" und "Deckscheibe" sind zur Unterscheidung der beiden Scheiben bei einer erfindungsgemäßen Verbundscheibe gewählt. Mit den Begriffen ist keine Aussage über die geometrische Anordnung verbunden. Ist die erfindungsgemäße Verbundscheibe beispielsweise dafür vorgesehen, in einer Öffnung, beispielsweise eines Fahrzeugs oder eines Gebäudes, den Innenraum gegenüber der äußeren Umgebung abzutrennen, so kann das Substrat dem Innenraum oder der äußeren Umgebung zugewandt sein.

Die elektrisch leitfähige Schicht enthält bevorzugt eine transparente, elektrisch leitfähige Beschichtung. Transparent bedeutet hier durchlässig für elektromagnetische Strahlung, vorzugsweise elektromagnetische Strahlung einer Wellenlänge von 300 nm bis 1.300 nm und insbesondere für sichtbares Licht.

Erfindungsgemäße elektrisch leitfähige Schichten sind beispielsweise aus DE 20 2008 017 611 U1, EP 0 847 965 B1 oder WO2012/052315 A1 bekannt. Sie enthalten typischerweise eine oder mehrere, beispielsweise zwei, drei oder vier elektrisch leitfähige, funktionelle Schichten. Die funktionellen Schichten enthalten bevorzugt zumindest ein Metall, beispielsweise Silber, Gold, Kupfer, Nickel und oder Chrom, oder eine Metalllegierung. Die funktionellen Schichten enthalten besonders bevorzugt mindestens 90 Gew. % des Metalls, insbesondere mindestens 99,9 Gew. % des Metalls. Die funktionellen Schichten können aus dem Metall oder der Metalllegierung bestehen. Die funktionellen Schichten enthalten besonders bevorzugt Silber oder eine silberhaltige Legierung. Solche funktionelle Schichten weisen eine besonders vorteilhafte elektrische Leitfähigkeit bei gleichzeitiger hoher Transmission im sichtbaren Spektralbereich auf. Die Dicke einer funktionellen Schicht beträgt bevorzugt von 5 nm bis 50 nm, besonders bevorzugt von 8 nm bis 25 nm. In diesem Bereich für die Dicke der funktionellen Schicht wird eine vorteilhaft hohe Transmission im sichtbaren Spektralbereich und eine besonders vorteilhafte elektrische Leitfähigkeit erreicht.

Typischerweise ist jeweils zwischen zwei benachbarten funktionellen Schichten zumindest eine dielektrische Schicht angeordnet. Bevorzugt ist unterhalb der ersten und/oder oberhalb der letzten funktionellen Schicht eine weitere dielektrische Schicht angeordnet. Eine dielektrische Schicht enthält zumindest eine Einzelschicht aus einem dielektrischen Material, beispielsweise enthaltend ein Nitrid wie Siliziumnitrid oder ein Oxid wie Aluminiumoxid. Dielektrische Schicht können aber auch mehrere Einzelschichten umfassen, beispielsweise Einzelschichten eines einem dielektrischen Material, Glättungsschichten, Anpassungsschichten, Blockerschichten und / oder Antireflexionsschichten. Die Dicke einer dielektrischen Schicht beträgt beispielsweise von 10 nm bis 200 nm.

Dieser Schichtaufbau wird im Allgemeinen durch eine Folge von Abscheidevorgängen erhalten, die durch ein Vakuumverfahren wie die magnetfeldgestützte Kathodenzerstäubung durchgeführt werden.

Weitere geeignete elektrisch leitfähige Schichten enthalten bevorzugt Indium-Zinnoxid (ITO), fluordotiertes Zinnoxid (SnO₂:F) oder aluminiumdotiertes Zinkoxid (ZnO:AI).

Die elektrisch leitfähige Schicht kann prinzipiell jede Beschichtung sein, die elektrisch kontaktiert werden kann. Soll die erfindungsgemäße Scheibe die Durchsicht ermöglichen, wie es beispielsweise bei Scheiben im Fensterbereich der Fall ist, so ist die elektrisch leitfähige Schicht bevorzugt transparent. In einer vorteilhaften Ausgestaltung ist die elektrisch leitfähige Schicht eine Schicht oder ein Schichtaufbau mehrerer Einzelschichten mit einer Gesamtdicke von kleiner oder gleich 2 µm, besonders bevorzugt kleiner oder gleich 1 µm.

Eine vorteilhafte erfindungsgemäße transparente elektrisch leitfähige Schicht weist einen Flächenwiderstand von 0,4 Ohm/Quadrat bis 200 Ohm/Quadrat auf. In einer besonders bevorzugten Ausgestaltung weist die erfindungsgemäße elektrisch leitfähige Schicht einen Flächenwiderstand von 0,5 Ohm/Quadrat bis 20 Ohm/Quadrat auf. Beschichtungen mit derartigen Flächenwiderständen eignen sich besonders zur Beheizung von Fahrzeugscheiben bei typischen Bordspannungen von 12 V bis 48 Volt oder bei Elektrofahrzeugen mit typischen Bordspannungen von bis zu 500 V.

Die elektrisch leitfähige Schicht kann sich über die gesamte Oberfläche einer Seite der Trägerfolie erstrecken. Die elektrisch leitfähige Schicht kann sich alternativ aber auch nur über einen Teil der Oberfläche der Trägerfolie erstrecken. Die elektrisch leitfähige Schicht kann eine oder mehrere unbeschichtete Zonen aufweisen. Diese Zonen können für elektromagnetische Strahlung durchlässig sein und sind beispielsweise als Datenübertragungsfenster oder Kommunikationsfenster bekannt.

In einer vorteilhaften Ausgestaltung einer erfindungsgemäßen Verbundscheibe ist die elektrisch leitfähige Schicht um eine Breite von 2 mm bis 50 mm, bevorzugt von 5 mm bis 20 mm vom Rand der Verbundscheibe entfernt angeordnet. Die elektrisch leitfähige Schicht weist dann keinen Kontakt zur Atmosphäre auf und ist im Inneren der Verbundscheibe durch die Zwischenschichten vorteilhaft vor Beschädigungen und Korrosion geschützt.

Die elektrische Zuleitung ist bevorzugt als Folienleiter oder flexibler Folienleiter (Flachleiter, Flachbandleiter) ausgebildet. Unter Folienleiter wird ein elektrischer Leiter verstanden, dessen Breite deutlich größer ist als seine Dicke. Ein solcher Folienleiter ist beispielsweise ein Streifen oder Band enthaltend oder bestehend aus Kupfer, verzinntem Kupfer, Aluminium, Silber, Gold oder Legierungen davon. Der Folienleiter weist beispielsweise eine Breite von 2 mm bis 16 mm und eine Dicke von 0,03 mm bis 0,1 mm auf. Der Folienleiter kann eine isolierende, bevorzugt polymere Ummantelung, beispielsweise auf Polyimid-Basis aufweisen. Folienleiter, die sich zur Kontaktierung von elektrisch leitfähigen Beschichtungen in Scheiben eignen, weisen lediglich eine Gesamtdicke von beispielsweise 0,3 mm auf. Derart dünne Folienleiter können ohne Schwierigkeiten zwischen den einzelnen Scheiben in der thermoplastischen Zwischenschicht eingebettet werden. In einem Folienleiterband können sich mehrere voneinander elektrisch isolierte, leitfähige Schichten befinden.

Alternativ können auch dünne Metalldrähte als elektrische Zuleitung verwendet werden. Die Metalldrähte enthalten insbesondere Kupfer, Wolfram, Gold, Silber oder Aluminium oder Legierungen mindestens zweier dieser Metalle. Die Legierungen können auch Molybdän, Rhenium, Osmium, Iridium, Palladium oder Platin enthalten.

Die elektrische Leitungsverbindung zwischen dem Anschlussbereiche der elektrisch leitfähigen Schicht auf der Trägerfolie und der elektrischen Zuleitung erfolgt bevorzugt über elektrisch leitfähige Kleber, die eine sichere und dauerhaft elektrische Leitungsverbindung zwischen Anschlussbereich und Zuleitung ermöglichen. Alternativ kann die elektrische Leitungsverbindung auch durch Klemmen erfolgen, da die Klemmverbindung durch den Laminiervorgang verrutschungssicher fixiert wird. Alternativ kann die Zuleitung auch auf den Anschlussbereich aufgedruckt werden, beispielsweise mittels einer metallhaltigen und insbesondere silberhaltigen, elektrisch leitfähigen Druckpaste.

In einer vorteilhaften Ausgestaltung der Erfindung weist die erfindungsgemäße Verbundscheibe ein Lichteinstrahlmittel und ein Lichtablenkmittel auf. Lichteinstrahlmittel und Lichtablenkmittel sind dabei in oder am Substrat und/oder an der Deckscheibe oder zwischen den Zwischenschichten beziehungsweise der Trägerfolie angeordnet.

Das Lichteinstrahlmittel umfasst erfindungsgemäß zumindest eine Lichtquelle, bevorzugt eine LED oder OLED. Der besondere Vorteil liegt in den kleinen Abmessungen und der geringen Leistungsaufnahme. Der von der Lichtquelle emittierte Wellenlängenbereich kann im Bereich des sichtbaren Lichtes frei gewählt werden, beispielsweise nach praktischen und/oder ästhetischen Gesichtspunkten. Das Lichteinstrahlmittel kann optische Elemente umfassen, insbesondere zur Lenkung des Lichts, bevorzugt einen Reflektor und/oder einen Lichtwellenleiter, beispielsweise eine Glasfaser oder eine polymere optische Faser. Das Lichteinstrahlmittel kann an einer beliebigen Stelle des Substrats oder der Deckscheibe angeordnet sein, insbesondere am Seitenrand des Substrats oder der Deckscheibe oder in einer kleinen Ausnehmung inmitten von Substrat oder Deckscheibe.

Das Lichtablenkmittel umfasst bevorzugt Partikel, Punktraster, Aufkleber, Anlagerungen, Einkerbungen, Einritzungen, Strichraster, Aufdrucke und / oder Siebdrucke und ist dazu geeignet, das im Substrat oder in der Deckscheibe transportierte Licht aus demselben auszukoppeln.

Das Lichtablenkmittel kann an jeder beliebigen Position auf der Ebene des Substrats oder der Deckscheibe angeordnet sein. Besonders vorteilhaft ist es, wenn das Lichtablenkmittel im Bereich oder in der unmittelbaren Umgebung des Berührungsbereichs angeordnet ist und so ein schnelles Auffinden des ansonsten kaum sichtbaren Berührungsbereichs ermöglicht. Dies ist insbesondere bei Nacht oder Dunkelheit besonders vorteilhaft.

Alternativ kann Licht durch einen Lichtleiter, der auf dem Substrat, der Zwischenschicht oder der Deckscheibe angeordnet ist, an den Berührungsbereich herangeführt werden und diesen markieren.

Alternativ oder in Kombination kann das Lichteinstrahlmittel zusammen mit dem Lichtablenkmittel eine Information auf der Scheibe visualisieren, beispielsweise den Schaltzustand des kapazitiven Schaltbereichs wiedergeben oder anzeigen, ob beispielsweise eine elektrische Funktion eingeschaltet oder ausgeschaltet ist.

In einer alternativen vorteilhaften Ausgestaltung der erfindungsgemäßen Verbundscheibe ist der Berührungsbereich durch eine aktive Lichtquelle direkt markierbar oder markiert, bevorzugt durch eine Leuchtdiode (LED), eine organische Leuchtdiode (OLED), eine Glühbirne oder andere aktive Leuchtkörper, wie ein lumineszentes Material, bevorzugt ein fluoreszierendes oder phosphoreszierendes Material.

In einer weiteren alternativen vorteilhaften Ausgestaltung der erfindungsgemäßen Verbundscheibe ist der Berührungsbereich durch einen farbigen, bevorzugt einen weißen oder schwarzen, Aufdruck, beispielsweise einem Siebdruck, auf dem transparenten Substrat, der Zwischenschicht oder der Deckscheibe, markiert. Dies hat den besonderen Vorteil, dass der Berührungsbereich unabhängig von einer Spannungsquelle und dauerhaft markiert ist. Der Aufdruck kann auch ein lumineszentes Material, bevorzugt ein fluoreszierendes oder phosphoreszierendes Material enthalten und/oder nachleuchtend sein.

In einer bevorzugten Ausgestaltung sind die Stromsammelleiter als Streifen einer elektrisch leitfähigen Folie ausgebildet. Die leitfähige Folie enthält bevorzugt Aluminium, Kupfer, verzinntes Kupfer, Gold, Silber, Zink, Wolfram und/oder Zinn oder Legierungen davon, besonders bevorzugt Kupfer.

Die Dicke der Stromsammelleiter beträgt bevorzugt von 10 µm bis 500 µm, besonders bevorzugt von 30 µm bis 200 µm, beispielsweise 50 µm oder 100 µm. Stromsammelleiter aus elektrisch leitfähigen Folien mit diesen Dicken sind technisch einfach zu realisieren und weisen eine vorteilhafte Stromtragfähigkeit auf.

Die Länge der Stromsammelleiter hängt von der Gestaltung der Verbundscheibe ab, insbesondere von der Länge der Kante, entlang derer die Stromsammelleiter angeordnet ist, und die Anzahl der zu kontaktierenden Heizdrähte, und kann vom Fachmann im Einzelfall geeignet gewählt werden. Unter der Länge der typischerweise streifenartigen Stromsammelleiter wird ihre längere Dimension verstanden, entlang derer sie üblicherweise mit den verschiedenen Heizdrähten oder Heizdrahtabschnitten kontaktiert sind.

Die Breite der Stromsammelleiter beträgt bevorzugt von 2 mm bis 20 mm, besonders bevorzugt von 5 mm bis 10 mm. Damit werden gute Ergebnisse erzielt hinsichtlich der Heizleistung, aber auch der optischen Unauffälligkeit.

Die Stromsammelschienen können direkt oder beispielsweise über eine Lotmasse oder einen elektrisch leitfähigen Kleber mit den Heizdrähten elektrisch leitend verbunden sein.

In einer bevorzugten Ausgestaltung der Erfindung erfolgt der Anschluss der Verbindungskabel zur externen Spannungsversorgung im Bereich einer der Seitenkanten, im Beispiel einer Seitenscheibe eines Fahrzeugs vorzugsweise im Bereich der Unterkante. Dadurch können die Verbindungskabel in der Fahrzeugkarosserie verborgen werden. Die Seitenscheibe weist dazu bevorzugt zumindest eine Zuleitung auf, welche mit einer Stromsammelschiene elektrisch kontaktiert ist und ausgehend von den Stromsammelleitern zur Unterkante verläuft. Bevorzugt ist jede Stromsammelleiter mit solch einer Zuleitung versehen. Die Zuleitungen können beispielsweise in Form einer geraden Strecke zur Unterkante verlaufen, um dort (beispielsweise im Bereich der Projektion der Stromsammelschiene auf die Unterkante) kontaktiert zu werden. Die Zuleitungen können bereits innerhalb des Laminats, also vor Erreichen der Unterkante enden und mit einem Flachleiter kontaktiert sein. Alternativ können sich die Zuleitungen über die Unterkante hinaus erstrecken zur Kontaktierung mit den externen Verbindungskabeln außerhalb des Laminats.

Die Zuleitung in der Verbundscheibe ist bevorzugt als Streifen einer elektrisch leitfähigen Folie ausgebildet. Die leitfähige Folie enthält bevorzugt Aluminium, Kupfer, verzinntes Kupfer, Gold, Silber, Zink, Wolfram und/oder Zinn oder Legierungen davon, besonders bevorzugt Kupfer. Die Dicke der Folie beträgt bevorzugt von 10 µm bis 500 µm, besonders bevorzugt von 30 µm bis 200 µm, beispielsweise 50 µm oder 100 µm. Die Breite der Zuleitungen beträgt bevorzugt von 2 mm bis 20 mm, besonders bevorzugt von 5 mm bis 10 mm. Vorteilhafterweise bestehen die Zuleitungen aus der gleichen Folie wie die Stromsammelleiter.

In einer bevorzugten Ausgestaltung enthält der Heizdraht Aluminium, Kupfer, verzinntes Kupfer, Gold, Silber, Zink, Wolfram und/oder Zinn oder Legierungen davon, besonders bevorzugt Kupfer und/oder Wolfram. Das ist für die Heizleistung vorteilhaft.

Die Dicke des Heizdrahts beträgt bevorzugt von 10 µm bis 200 µm, besonders bevorzugt von 20 µm bis 100 µm, beispielsweise 30 µm oder 70 µm. Damit werden gute Heizwirkungen erreicht. Zudem sind solche Drähte hinreichend dünn, um optisch unauffällig zu sein.

In einer bevorzugten Ausgestaltung der Erfindung beträgt die Heizleistung der Verbundscheibe mindestens 250 W/m². Damit wird eine vorteilhafte Heizwirkung erzielt.

Ein weiterer Aspekt der Erfindung umfasst ein Verfahren zur Herstellung einer Scheibenanordnung mit einer beheizbaren Verbundscheibe mit kapazitivem Schaltbereich, mindestens umfassend:
(a) Zurechtschneiden einer ersten Zwischenschicht (3) und Aufbringen einer transparenten, elektrisch leitfähigen Schicht (6) auf die Oberfläche einer Seite einer Trägerfolie (5) mittels Kathodenzerstäubung,
(b) Aufbringen von zwei Stromsammelleitern (22) auf die Oberfläche der ersten Zwischenschicht (3) und Aufbringen mindestens eines Heizdrahtes (21) auf die Oberfläche der ersten Zwischenschicht (3), wobei der Heizdraht (21) mit beiden Stromsammelleitern (22) elektrisch leitend verbunden wird,
(c) Herstellen einer Stapelfolge aus einem Substrat (1), der ersten Zwischenschicht (3) mit dem Heizdraht (21) und den Stromsammelleitern (22), einer Trägerfolie (5) mit einer elektrisch leitfähigen Schicht (6) und einer Deckscheibe (4) und
(d) Laminieren der Stapelfolge zu einer Verbundscheibe (100).

Das Aufbringen der elektrisch leitfähigen Schicht in Verfahrensschritt (a) kann durch an sich bekannte Verfahren erfolgen, bevorzugt durch magnetfeldunterstützte Kathodenzerstäubung. Das ist besonders vorteilhaft im Hinblick auf eine einfache, schnelle, kostengünstige und gleichmäßige Beschichtung des Substrats. Die elektrisch leitfähige Schicht kann aber auch beispielsweise durch Aufdampfen, chemische Gasphasenabscheidung (chemical vapour deposition, CVD), plasmagestützte Gasphasenabscheidung (PECVD) oder durch nasschemische Verfahren aufgebracht werden.

Die Trägerfolie kann nach Verfahrensschritt (a) einer Temperaturbehandlung unterzogen werden. Dabei wird die Trägerfolie mit der elektrisch leitfähigen Schicht auf eine Temperatur von mindestens 200°C, bevorzugt mindestens 300°C erwärmt. Die Temperaturbehandlung kann der Erhöhung der Transmission und / oder der Verringerung des Flächenwiderstands der elektrisch leitfähigen Schicht dienen.

In einer vorteilhaften Ausführungsform des erfindungsgemäßen Verfahrens wird mindestens eine Trennlinie, die die elektrisch leitfähige Schicht in mindestens einen kapazitiven Schaltbereich und mindestens einen Umgebungsbereich elektrisch unterteilt, bevorzugt durch Laserstrukturierung oder durch mechanisches oder chemisches Abtragen in die elektrisch leitfähige Schicht eingebracht.

Die Entschichtung einzelner Trennlinien in der elektrisch leitfähigen Schicht erfolgt vorzugsweise durch einen Laserstrahl. Verfahren zum Strukturieren dünner Metallfilme sind beispielsweise aus EP 2 200 097 A1 oder EP 2 139 049 A1 bekannt. Die Breite der Entschichtung beträgt bevorzugt 10 µm bis 1000 µm, besonders bevorzugt 30 µm bis 200 µm und insbesondere 70 µm bis 140 µm. In diesem Bereich findet eine besonders saubere und rückstandsfreie Entschichtung durch den Laserstrahl statt. Die Entschichtung mittels Laserstrahl ist besonders vorteilhaft, da die entschichteten Linien optisch sehr unauffällig sind und das Erscheinungsbild und die Durchsicht nur wenig beeinträchtigen. Die Entschichtung einer Linie mit einer Breite, die breiter ist als die Breite eines Laserschnitts, erfolgt durch mehrmaliges Abfahren der Linie mit dem Laserstrahl. Die Prozessdauer und die Prozesskosten steigen deshalb mit zunehmender Linienbreite an. Alternativ kann die Entschichtung durch mechanisches Abtragen sowie durch chemisches oder physikalisches Ätzen erfolgen.

Die erste beziehungsweise die zweite Zwischenschicht kann durch eine einzelne oder auch durch zwei oder mehrere Folien, die flächenmäßig übereinander angeordnet werden, ausgebildet werden.

Das Verbinden von Substrat und Deckscheibe in Verfahrensschritt (d) erfolgt bevorzugt unter Einwirkung von Hitze, Vakuum und/oder Druck. Es können an sich bekannte Verfahren zur Herstellung einer Verbundscheibe verwendet werden.

Es können beispielsweise sogenannte Autoklavverfahren bei einem erhöhten Druck von etwa 10 bar bis 15 bar und Temperaturen von 130 °C bis 145 °C über etwa 2 Stunden durchgeführt werden. An sich bekannte Vakuumsack- oder Vakuumringverfahren arbeiten beispielsweise bei etwa 200 mbar und 80 °C bis 110 °C. Die erste Scheibe, die thermoplastische Zwischenschicht und die zweite Scheibe können auch in einem Kalander zwischen mindestens einem Walzenpaar zu einer Scheibe verpresst werden. Anlagen dieser Art sind zur Herstellung von Scheiben bekannt und verfügen normalerweise über mindestens einen Heiztunnel vor einem Presswerk. Die Temperatur während des Pressvorgangs beträgt beispielsweise von 40 °C bis 150 °C. Kombinationen von Kalander- und Autoklavverfahren haben sich in der Praxis besonders bewährt. Alternativ können Vakuumlaminatoren eingesetzt werden. Diese bestehen aus einer oder mehreren beheizbaren und evakuierbaren Kammern, in denen die erste Scheibe und die zweite Scheibe innerhalb von beispielsweise etwa 60 Minuten bei verminderten Drücken von 0,01 mbar bis 800 mbar und Temperaturen von 80°C bis 170°C laminiert werden.

Die Stromsammelleiter und die Heizdrähte werden bevorzugt beim oder vor dem Aufbringen auf die erste Zwischenschicht zumindest bereichsweise erwärmt.

Das Anbringen der Stromsammelleiter kann insbesondere durch Auflegen erfolgen, aber auch durch Aufkleben. Das Erwärmen der Stromsammelleiter erfolgt beispielsweise mit einem Lötkolben. Durch das Erwärmen soll die thermoplastische Zwischenschicht leicht angeschmolzen und so mit dem Stromsammelleiter verbunden werden. Die Temperatur beträgt bevorzugt von 150 °C bis 240 °C.

Statt der Verwendung eines Lötkolbens ist es auch möglich, die Stromsammelleiter mit einem Plotter und einem beheizbaren Rad auf die Zwischenschicht aufzubringen oder in deren Oberfläche einzubetten.

Soll der Heizdraht zwischen zwei Stromsammelleitern sandwichartig angeordnet werden, so wird der obere Stromsammelleiter (also derjenige, der beim Auflegen auf die Zwischenschicht einen größeren Abstand zur Zwischenschicht aufweist) bevorzugt mit einer höheren Temperatur fixiert, beispielsweise von 300 °C bis 360 °C).

Das Aufbringen des Heizdrahtes erfolgt bevorzugt mit einem sogenannten Plotter. Dabei wird der Heizdraht mit einem Roboterarm bewegt und von einer Spule abgewickelt. Der Heizdraht wird bevorzugt erhitzt beim Aufbringen, so dass die thermoplastische Zwischenschicht anschmilzt und sich mit dem Heizdraht verbindet. Insbesondere soll der Heizdraht vollständig oder teilweise in die Oberfläche der Zwischenschicht eindringen, so dass er in die Oberfläche der Zwischenschicht eingebettet ist.

Ein weiterer Aspekt der Erfindung umfasst die Verwendung der erfindungsgemäßen Scheibenanordnung mit einer elektrisch beheizbaren Scheibe mit kapazitivem Schaltbereich in Gebäuden, insbesondere im Zugangsbereich, Fensterbereich, Dachbereich oder Fassadenbereich, als Einbauteil in Möbeln und Geräten, in Fortbewegungsmitteln für den Verkehr auf dem Lande, in der Luft oder zu Wasser, insbesondere in Zügen, Schiffen und Kraftfahrzeugen beispielsweise als Windschutzscheibe, Heckscheibe, Seitenscheibe und / oder Dachscheibe.

Gezeigt ist auch die Verwendung des kapazitiven Schaltbereichs zur elektrischen Steuerung einer Funktion innerhalb oder außerhalb der Verbundscheibe, bevorzugt einer Heizfunktion, einer Beleuchtung, insbesondere eines in der Verbundscheibe angeordneten Leuchtmittels wie einer LED, einer Änderung der optischen Transparenz einer funktionellen Zwischenschicht, insbesondere einer Suspended Particle Device (SPD)-Schicht oder einer elektrochromen Zwischenschicht.

Im Folgenden wird die Erfindung anhand einer Zeichnung und Ausführungsbeispielen näher erläutert. Die Zeichnung ist eine schematische Darstellung und nicht maßstabsgetreu. Die Zeichnung schränkt die Erfindung in keiner Weise ein.

Es zeigen:
- Figur 1A: eine Draufsicht auf eine Ausgestaltung einer erfindungsgemäßen Scheibenanordnung mit einer erfindungsgemäßen Verbundscheibe,
- Figur 1B: eine Querschnittsdarstellung entlang der Schnittlinie A-A' aus Figur 1A,
- Figur 1C: eine vergrößerte Darstellung der erfindungsgemäßen Trägerfolie aus Figur 1A,
- Figur 1D: eine Querschnittsdarstellung entlang der Schnittlinie B-B' aus Figur 1C,
- Figur 2A: eine Draufsicht auf eine alternative Ausgestaltung einer erfindungsgemäßen Scheibenanordnung mit einer erfindungsgemäßen Verbundscheibe,
- Figur 2B: eine Querschnittsdarstellung entlang der Schnittlinie A-A' aus Figur 2A,
- Figur 2C: eine Querschnittsdarstellung einer alternativen Ausgestaltung einer erfindungsgemäßen Verbundscheibe entlang der Schnittlinie A-A' aus Figur 2A, und
- Figur 2D: eine Querschnittsdarstellung einer alternativen Ausgestaltung einer erfindungsgemäßen Verbundscheibe entlang der Schnittlinie A-A' aus Figur 2A, und
- Figur 3: eine Querschnittsdarstellung einer Weiterbildung einer erfindungsgemäßen Verbundscheibe entlang der Schnittlinie A-A' aus Figur 2A, und
- Figur 4: ein detailliertes Flussdiagramm einer Ausführungsform des erfindungsgemäßen Verfahrens.

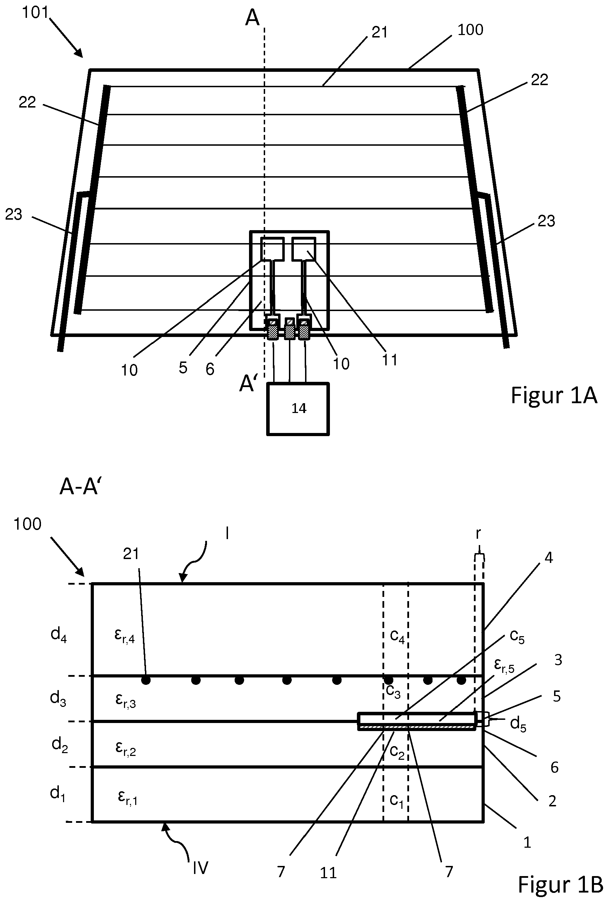

Figur 1A zeigt eine Draufsicht auf eine beispielhafte Ausgestaltung einer erfindungsgemäßen Scheibenanordnung 101 mit einer erfindungsgemäßen Verbundscheibe 100.

In Figur 1B ist eine Querschnittsdarstellung entlang der Schnittlinie A-A' aus Figur 1A dargestellt. Die Verbundscheibe 100 umfasst hier beispielsweise ein Substrat 1 und eine Deckscheibe 4, die über eine erste Zwischenschicht 3 und eine zweite Zwischenschicht 2 miteinander verbunden sind. Die Verbundscheibe 100 ist beispielsweise eine Fahrzeugscheibe und insbesondere die Windschutzscheibe eines Personenkraftwagens. Die Abmessungen der Verbundscheibe 100 betragen beispielsweise 0,9 m x 1,5 m. Das Substrat 1 ist beispielsweise dafür vorgesehen, in Einbaulage dem Innenraum zugewandt zu sein. Das heißt, die außenseitige Oberfläche IV des Substrats 1 ist vom Innenraum aus zugänglich, wogegen die außenseitige Oberfläche I der Deckscheibe 4 bezüglich des Fahrzeuginnenraums nach außen weist. Substrat 1 und Deckscheibe 4 bestehen beispielsweise aus Natron-Kalkglas. Die Dicke d₁ des Substrats 1 beträgt beispielsweise 1,6 mm und die Dicke d₄ der Deckscheibe 4 beträgt 2,1 mm. Es versteht sich, dass Substrat 1 und Deckscheibe 4 beliebige Dicken aufweisen können und beispielsweise auch gleich dick ausgebildet sein können. Die Zwischenschichten 2,3 sind thermoplastische Zwischenschichten und bestehen aus Polyvinylbutyral (PVB). Sie weisen jeweils eine Dicke d_{2/3} von beispielsweise 0,38 mm auf. Im mittleren, unteren Abschnitt der Verbundscheibe 100 ist zwischen der ersten Zwischenschicht 2 und der zweiten Zwischenschicht 3 eine Trägerfolie 5 mit beispielsweise vier kapazitiven Schaltbereichen 10 angeordnet.

Im dargestellten Beispiel sind zwischen der ersten Zwischenschicht 3 und der Deckscheibe 4 beispielsweise acht Heizdrähte 21 angeordnet, die parallel zu den Grundseiten der trapezförmigen Verbundscheibe 100 verlaufen. Die Heizdrähte 21 sind an ihren Enden jeweils mit einem Stromsammelleiter 22 verbunden, wobei die Stromsammelleiter 22 jeweils mit einer Zuleitung 23 verbunden sind. Die Heizdrähte 21 sind somit in einer Parallelschaltung derart mit den Stromsammelleitern 22 verbunden, dass bei Anlegen einer elektrischen Spannung an die Stromsammelleiter 22 (über die Zuleitungen 23) ein Heizstrom durch die Heizdrähte 21 fließen kann. Der Heizstrom führt zu einer Beheizung des Heizdrahts 21 aufgrund einer joulschen Wärmeentwicklung, so dass die Verbundscheibe 100 insgesamt elektrisch beheizbar ist.

Die Heizdrähte 21 bestehen beispielsweise jeweils aus einem 30 µm dicken Wolframdraht, der eine elektrisch isolierende Ummantelung mit beispielsweise schwarzer oder grüner Farbe aufweist. Diese Ummantelung hat mehrere Vorteile: der Kupferdraht kann je nach den Erfordernissen der Ausgestaltung angeordnet werden und beispielsweise auch andere elektrisch leitfähige Strukturen überkreuzen, ohne dass ein Kurzschluss auftritt. Des Weiteren ist der Heizdraht durch die polymere Ummantelung vor Korrosion geschützt. Zusätzlich ist die Reflexion an der farbigen Ummantelung geringer als an dem metallenen Kupfer-Innenleiter, so dass der Heizdraht optisch weniger auffällig ist.

Jeder Heizdraht 21 ist an seinen Enden mit jeweils einem Stromsammelleiter 22 elektrisch kontaktiert. Die Stromsammelleiter 22 sind als Streifen einer Kupferfolie ausgebildet, mit einer Dicke von beispielsweise 100 µm und einer Breite von beispielsweise 7 mm. Wird an die Stromsammelleiter 22 eine Spannung angelegt, so fließt ein Strom durch die Heizdrähte 21, wodurch die Heizwirkung entsteht. Die Spannung kann die übliche KFZ-Bordspannung von 14 V sein, oder auch eine Spannung von beispielsweise 42 V oder 48 V.

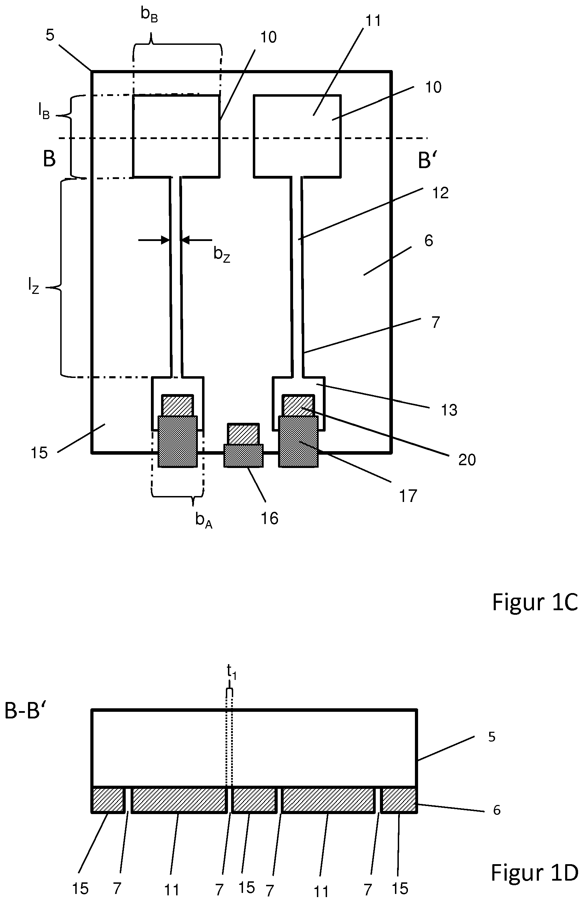

Figur 1C zeigt eine vergrößerte Darstellung der erfindungsgemäßen Trägerfolie 5 aus Figur 1A. Figur 1D zeigt eine dazugehörige Querschnittsdarstellung entlang der Schnittlinie B-B' aus Figur 1C.

Die Trägerfolie 5 ist in diesem Beispiel eine transparente Polyethylenterephthalat (PET)-Folie mit einer Dicke d₅ von 0,05 mm. Auf der Trägerfolie 5 ist eine transparente elektrisch leitfähige Schicht 6 angeordnet. Die elektrische leitfähige Schicht 6 ist ein Schichtensystem, welches beispielsweise drei elektrisch leitfähige Silberschichten enthält, die durch dielektrische Schichten voneinander getrennt sind.

Die elektrisch leitfähige Schicht 6 erstreckt sich beispielsweise über eine gesamte Seite der Trägerfolie 5. Im dargestellten Ausführungsbeispiel ist die elektrisch leitfähige Schicht 6 auf derjenigen Seite der Trägerfolie 5 angeordnet, die dem Substrat 1 zugewandt ist. Die Trägerfolie 5 ist um einen Abstand von etwa 8 mm vom Scheibenrand ins Scheibeninnere versetzt. Dieser Bereich wird durch Verkleben der beiden Zwischenschichten 2,3 während des Laminierens hermetisch versiegelt, so dass die elektrisch leitfähige Schicht 6 vor Feuchtigkeit aus der Umgebung der Verbundscheibe 100 und damit vor Korrosion und Beschädigung geschützt ist. Alternativ wäre es möglich die Trägerfolie 5 in einem Randbereich beschichtungsfrei zu lassen oder die elektrisch leitfähige Schicht 6 dort zur entfernen.

Die elektrisch leitfähige Schicht 6 ist durch beschichtungsfreie Trennlinien 7 in unterschiedliche, voneinander elektrisch isolierte Bereiche unterteilt. In dem in Figur 1C dargestellten Beispiel sind zwei kapazitive Schaltbereiche 10 von einem gemeinsamen Umgebungsbereich 15 elektrisch unterteilt. Jeder Schaltbereich 10 umfasst einen Berührungsbereich 11, der annähernd quadratisch ausgebildet ist und in einen streifenförmigen Zuleitungsbereich 12 übergeht. Die Breite b_{B} und die Länge l_{B} des Berührungsbereichs 11 beträgt jeweils beispielsweise 40 mm. Die Breite b_{Z} des Zuleitungsbereichs 12 beträgt beispielsweise 1 mm. Das Verhältnis von b_{Z}:b_{B} beträgt somit etwa 1:40. Der Zuleitungsbereich 12 ist mit einem Anschlussbereich 13 verbunden. Der Anschlussbereich 13 hat eine quadratische Form und einer Kantenlänge b_{A} von beispielsweise 12 mm. Die Länge l_{Z} des Zuleitungsbereichs beträgt etwa 48 mm.

Die Trennlinie 7 hat lediglich eine Breite t₁ von beispielsweise 100 µm und ist beispielsweise durch Laserstrukturierung in die elektrisch leitfähige Schicht 6 eingebracht. Trennlinien 7 mit einer derart geringen Breite sind optisch kaum wahrnehmbar und stören die Durchsicht durch die Verbundscheibe 100 nur wenig, was besonders für eine Verwendung in Fahrzeugen von besonderer Wichtigkeit für die Fahrsicherheit ist und außerdem besonders ästhetisch ist.

Der Anschlussbereich 13 ist über eine elektrische Leitungsverbindung 20 mit einem Folienleiter 17 elektrisch leitend verbunden. Eine sichere elektrisch leitende Verbindung wird dabei bevorzugt durch einen elektrisch leitfähigen Kleber erzielt. Der Folienleiter 17 besteht beispielsweise aus einer 50 µm dicken Kupferfolie und ist beispielsweise außerhalb der Anschlussbereichs 13 mit einer Polyimidschicht isoliert.

Dadurch kann der Folienleiter 17 ohne elektrischen Kurzschluss über den Umgebungsbereich 15 hinweg über den unteren Rand der Verbundscheibe 100 hinausgeführt werden. Es versteht sich, dass die elektrische Leitungsverbindung des Anschlussbereichs nach außen auch über isolierte Drähte oder über einen Bereich, in dem die elektrisch leitfähige Schicht des Umgebungsbereichs unterbrochen ist, nach außen geführt werden kann.

Der Folienleiter 17 ist hier beispielsweise außerhalb der Verbundscheibe 100 mit einer kapazitiven Sensorelektronik 14 verbunden. Des Weiteren ist der Umgebungsbereich 15 über einen weiteren Anschlussbereich 16 ebenfalls mit der Sensorelektronik 14 verbunden. Die Sensorelektronik 14 ist dazu geeignet Kapazitätsänderungen des Schaltbereichs 10 gegenüber dem Umgebungsbereich 15 präzise zu messen und in Abhängigkeit eines Schwellwerts ein Schaltsignal beispielsweise an den CAN-Bus eines Fahrzeugs weiter zu geben. Über das Schaltsignal können beliebige Funktionen im Fahrzeug geschaltet werden. Beispielsweise kann die elektrische Heizfunktion der Verbundscheibe 100 durch Anlegen und Abschalten einer elektrischen Spannung am Heizschaltkreis aus Stromsammelleitern und Heizdrähten ein- oder ausgeschaltet werden.

Wird die Verbundscheibe 100 beispielsweise als Windschutzscheibe in einem Kraftfahrzeug verwendet, kann die Länge des Zuleitungsbereichs 12 so gewählt werden, dass der Fahrer des Fahrzeugs oder der Beifahrer den Berührungsbereich 11 des Schaltbereichs 10 bequem erreichen.

Im dargestellten Ausgestaltungsbeispiel ist die Aufbau und die Abstimmung der Sensorelektronik 14 derart abgestimmt, dass bei Berührung der außenseitigen Scheibenoberfläche IV des Substrats 1 über dem Berührungsbereich 11 des kapazitiven Schaltbereichs 10 ein Schaltsignal ausgelöst wird, wobei bei Berührung der außenseitigen Scheibenoberfläche I der Deckscheibe 4 über dem kapazitiven Schaltbereich 10 kein Schaltsignal ausgelöst wird. Dazu werden die Dicken und die Materialien der erfindungsgemäßen Verbundscheibe 100 erfindungsgemäß so gewählt, dass der Flächenkapazitätsbelag c_{I} zwischen dem Berührungsbereich 11 und der außenseitigen Oberfläche IV des Substrats 1 größer als der Flächenkapazitätsbelag c_{A} zwischen dem Berührungsbereich 11 und der außenseitigen Oberfläche I der Deckscheibe 4 ist.

Der Flächenkapazitätsbelag c_{I} beziehungsweise c_{A} ist im Rahmen der vorliegenden Erfindung definiert als die Kapazität eines Plattenkondensators desjenigen Bereichs der Verbundscheibe 100, der sich durch orthogonale Projektion des Berührungsbereichs 11 zwischen dem Berührungsbereich 11 und der außenseitigen Oberfläche IV des Substrats 1 beziehungsweise der außenseitigen Oberfläche I der Deckscheibe 4 ergibt, wobei die sich ergebende Kapazität auf die Fläche des Berührungsbereichs normiert wird.

Im in Figur 1B detailliert dargestellten Beispiel ergibt sich der Flächenkapazitätsbelag c_{I} zwischen dem Berührungsbereich 11 und der außenseitigen Oberfläche IV des Substrats 1 als die Serienschaltung der Einzelkapazitätsbeläge (1/c₁+1/c₂)⁻¹, wobei sich der Einzelkapazitätsbelag zu cᵢ=ε₀^{∗}ε_{r,i}/dᵢ ergibt. Dies entspricht der Kapazität Cᵢ der jeweiligen Einzellage mit relativer Permittivität ε_{r,i} und Dicke dᵢ, normiert auf die Fläche A des Berührungsbereichs 11, also cᵢ=Cᵢ/A.

Des Weiteren ergibt sich der Flächenkapazitätsbelag c_{I} zwischen dem Berührungsbereich 11 und der außenseitigen Oberfläche I der Deckscheibe 4 als die Serienschaltung der Einzelkapazitätsbeläge (1/c₃+1/c₄+1/c₅)⁻¹.

Die relative Permittivität des Substrats 1 und der Deckscheibe 4 betragen hier beispielsweise ε_{r,1}= ε_{r,4}=7; die relative Permittivität der ersten Zwischenschicht 3 und der zweiten Zwischenschicht 2 betragen hier beispielweise ε_{r,2}= ε_{r,3}=2,6 und die relative Permittivität der Trägerfolie 5 beträgt hier beispielsweise ε_{r,5}=3. Daraus ergibt sich ein Verhältnis der Flächenkapazitätsbelegungen c_{I}:c_{A} zu 1,2:1.

Des Weiteren ist in diesem Beispiel die Fläche A des Berührungsbereichs 11 und insbesondere dessen Breite b_{B} derart mit der Breite b_{Z} des Zuleitungsbereichs 12 abgestimmt, dass nur bei einer Berührung der außenseitigen Oberfläche IV des Substrats über dem Berührungsbereichs 11 (also in demjenigen Bereich der Oberfläche IV, der sich durch orthogonale Projektion des Berührungsbereichs 11 auf die Oberfläche IV ergibt) ein Schaltsignal ausgibt und nicht bei Berührung der Oberfläche IV über dem Zuleitungsbereich 12.

Wie Versuche der Erfinder überraschenderweise gezeigt haben, erhöht die Anwesenheit der Heizdrähte zwischen dem Berührungsbereich 11 der elektrisch leitfähigen Schicht 6 und der Deckscheibe 4 nochmals die Selektivität, das heißt die Empfindlichkeit bei einer Berührung auf der außenseitigen Oberfläche IV des Substrats 1 wird im Vergleich mit der Berührung der außenseitigen Oberfläche I der Deckscheibe 4 nochmals deutlich gesteigert. Dies war unerwartet und überraschend.

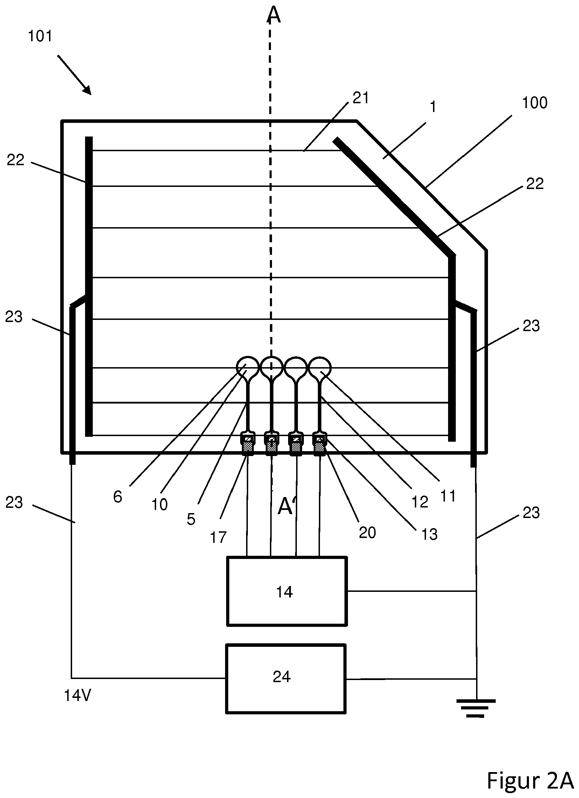

Figur 2A zeigt eine Draufsicht auf eine alternative beispielhafte Ausgestaltung einer erfindungsgemäßen Scheibenanordnung 101 mit einer erfindungsgemäßen Verbundscheibe 100.

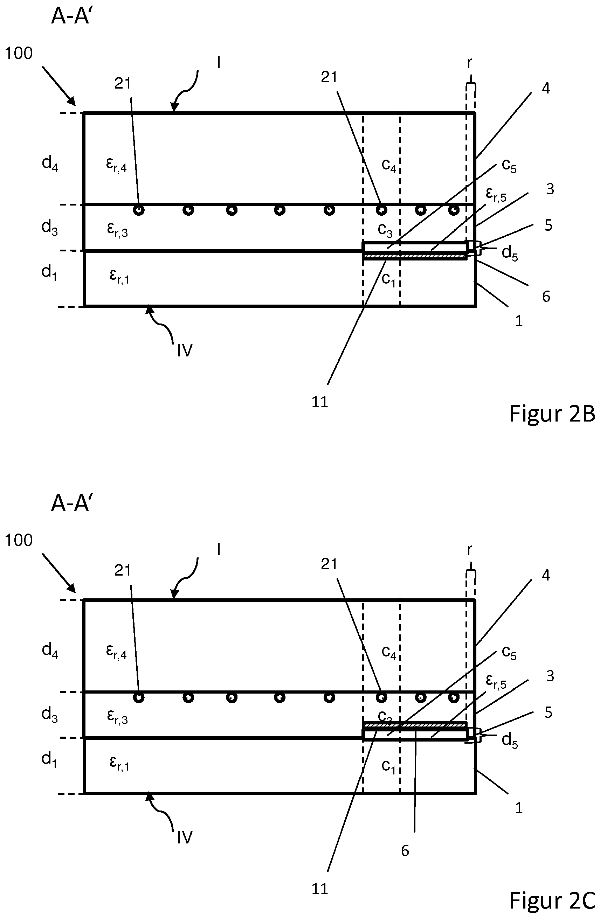

In Figur 2B ist eine Querschnittsdarstellung entlang der Schnittlinie A-A' aus Figur 2A dargestellt. Zur Vereinfachung ist der Folienleiter 17 nicht dargestellt. Die Verbundscheibe 100 umfasst hier beispielsweise ein Substrat 1 und eine Deckscheibe 4, die über eine erste Zwischenschicht 3 miteinander verbunden sind. Die Verbundscheibe 100 ist beispielsweise eine Fahrzeugscheibe und insbesondere die Seitenscheibe eines Personenkraftwagens. Die Abmessungen der Verbundscheibe 100 betragen beispielsweise 1,0 m x 0,6 m, wobei die Vorderkante der Seitenscheibe im Bereich der Oberkante abgeschrägt ist. Das Substrat 1 ist beispielsweise dafür vorgesehen, in Einbaulage dem Innenraum zugewandt zu sein. Das heißt, die außenseitige Oberfläche IV des Substrats 1 ist vom Innenraum aus zugänglich, wogegen die außenseitige Oberfläche I der Deckscheibe 4 nach außen weist. Substrat 1 und Deckscheibe 4 bestehen beispielsweise aus Natron-Kalkglas. Die Dicke d₁ des Substrats 1 beträgt beispielsweise 2,1 mm und die Dicke d₄ der Deckscheibe 4 beträgt beispielsweise ebenfalls 2,1 mm. Die erste Zwischenschicht 3 ist eine thermoplastische Zwischenschicht und besteht aus Polyvinylbutyral (PVB). Sie weist eine Dicke d₃ von 0,76 mm auf.

In die zur Deckscheibe 4 weisende Oberfläche der ersten Zwischenschicht 3 sind beispielsweise acht Heizdrähte 21 eingebettet. Die Heizdrähte 21 bestehen beispielsweise aus Kupfer und weisen eine Dicke von 30 µm auf. Jeder Heizdraht 21 ist an seinen Enden mit jeweils einem Stromsammelleiter 22 elektrisch kontaktiert. Die Stromsammelleiter 22 sind als Streifen einer Kupferfolie ausgebildet, mit einer Dicke von beispielsweise 100 µm und einer Breite von beispielsweise 7 mm. Wird an die Stromsammelleiter 22 eine Spannung angelegt, so fließt ein Strom durch die Heizdrähte 21, wodurch die Heizwirkung entsteht. Die Spannung kann die übliche KFZ-Bordspannung von 14 V sein, oder auch eine Spannung von beispielsweise 42 V oder 48 V. Im dargestellten Ausgestaltungsbeispiel sind Stromsammelleiter 22 mit einer Spannungsquelle 24 verbunden, die an einem Sammelleiter 22 ein Massepotential und an dem anderen Sammelleiter 22 eine Spannung von 14V bereitstellt.

Im mittleren, unteren Abschnitt der Verbundscheibe 100 sind zwischen der ersten Zwischenschicht 3 und dem Substrat 1 vier Trägerfolien 5 mit jeweils einem kapazitiven Schaltbereich 10 angeordnet. Die Trägerfolien 5 weisen an einem Ende eine tropfenförmige Ausgestaltung auf, die den Berührungsbereich 11 bildet. Der Berührungsbereich 11 ist über einen schmalen Bereich der Trägerfolie 5, dem Zuleitungsbereich 12 mit einem quadratischen Anschlussbereich 13 elektrisch leitend verbunden. In diesem Beispiel weist jede Trägerfolie 5 eine vollständige elektrisch leitfähige Schicht 6 auf, die nicht durch Trennlinien oder andere Isolierungen unterteilt ist. Das heißt die Trägerfolien 5 weisen hier keinen Umgebungsbereich auf.

Die Trägerfolie 5 ist in diesem Beispiel eine transparente Polyethylenterephthalat (PET)-Folie mit einer Dicke d₅ von 0,05 mm. Die elektrische leitfähige Schicht 6 ist ein Schichtensystem, welches beispielsweise drei elektrisch leitfähige Silberschichten enthält, die durch dielektrische Schichten voneinander getrennt sind.

Jeder Schaltbereich 10 umfasst einen Berührungsbereich 11, der annähernd tropfenförmig ausgebildet ist und in einen streifenförmigen Zuleitungsbereich 12 übergeht. Die Breite b_{B} und die Länge l_{B} des Berührungsbereichs 11 beträgt jeweils beispielsweise 40 mm. Die Breite b_{Z} des Zuleitungsbereichs 12 beträgt beispielsweise 1 mm. Das Verhältnis von b_{Z}:b_{B} beträgt somit etwa 1:40. Der Zuleitungsbereich 12 ist mit einem Anschlussbereich 13 verbunden. Der Anschlussbereich 13 hat eine quadratische Form mit abgerundeten Ecken und einer Kantenlänge b_{A} von beispielsweise 12 mm. Die Länge l_{Z} des Zuleitungsbereichs beträgt etwa 48 mm.

Die elektrisch leitfähige Schicht 6 erstreckt sich beispielsweise über die gesamte Oberfläche einer Seite der Trägerfolie 5. Die Trägerfolie 5 weist einen Randabstand von beispielsweise 15 mm zur nächstliegenden Seitenkante der Verbundscheibe 100 auf. Dieser Bereich wird durch Verkleben der ersten Zwischenschicht 3 mit dem Substrat 1 während des Laminierens hermetisch versiegelt, so dass die elektrisch leitfähige Schicht 6 vor Feuchtigkeit aus der Umgebung der Verbundscheibe 100 und damit vor Korrosion und Beschädigung geschützt ist. Im dargestellten Ausführungsbeispiel ist die elektrisch leitfähige Schicht 6 auf derjenigen Seite der Trägerfolie 5 angeordnet, die dem Substrat 1 zugewandt ist.

Der Anschlussbereich 13 ist über eine elektrische Leitungsverbindung 20 mit einem Folienleiter 17 elektrisch leitend verbunden. Eine sichere elektrisch leitende Verbindung wird dabei bevorzugt durch einen elektrisch leitfähigen Kleber erzielt. Der Folienleiter 17 besteht beispielsweise aus einer 50 µm dicken Kupferfolie und ist beispielsweise außerhalb der Anschlussbereichs 13 mit einer Polyimidschicht isoliert. Dadurch kann der Folienleiter 17 ohne elektrischen Kurzschluss über den Umgebungsbereich 15 hinweg über den unteren Rand der Verbundscheibe 100 hinausgeführt werden. Es versteht sich, dass die elektrische Verbindung des Anschlussbereichs 13 nach außen auch über isolierte Drähte oder über einen Bereich, in dem der Umgebungsbereich 15 unterbrochen ist, nach außen geführt werden kann.

Der Folienleiter 17 ist hier beispielsweise außerhalb der Verbundscheibe 100 mit einer kapazitiven Sensorelektronik 14 verbunden.

Wie bereits erwähnt, weist die Trägerfolie 5 in diesem Ausgestaltungsbeispiel keinen Umgebungsbereich auf, das heißt die elektrisch leitfähige Schicht 6 bildet vollständig den Berührungsbereich 11, den Zuleitungsbereich 12 und den Anschlussbereich 13. Um dennoch eine differenzielle Messung der Kapazität zu ermöglichen ist die Sensorelektronik 14 mit einer der Zuleitungen 23 der Stromsammelleiter 22 elektrisch leitend verbunden. In diesem Beispiel über die Zuleitung des Stromsammelleiters 22 der mit der Fahrzeugmasse verbunden ist (in Figur 2A rechts).

Die Sensorelektronik 14 ist dazu geeignet Kapazitätsänderungen des Schaltbereichs 10 gegenüber dem Heizschaltkreis aus Heizdrähten 21 und Stromsammelleiter 22 präzise zu messen und in Abhängigkeit eines Schwellwerts ein Schaltsignal beispielsweise an den CAN-Bus eines Fahrzeugs weiter zu geben. Dazu ist es besonders vorteilhaft, dass die kapazitive Schaltfläche 10 in Projektion durch die Verbundscheibe 100 mit einem der Heizdrähte 21 überlappt.

Über das Schaltsignal können beliebige Funktionen im Fahrzeug geschaltet werden. Beispielsweise kann die Spannungsversorgung 24 des Heizschaltkreis aus Heizdrähten 21 und Stromsammelleitern 22 gezielt ein- und ausgeschaltet oder geregelt werden und so die Heizfunktion der Verbundscheibe 100 gesteuert werden.

Alternativ oder zustätzlich kann die Verbundscheibe 100 eine Suspende Particle Device (SPD)- , eine elektrochrome oder eine andersartige Schicht oder Folie zur Steuerung der optischen Transparenz aufweisen, die durch das Schaltsignal in ihrer optischen Transparenz verändert werden kann, hier zum Beispiel mit vier Transparenzstufen, die jeweils über die vier kapazitiven Schaltbereiche 10 angewählt werden können. Es versteht sich, dass alternativ oder zusätzlich auch andere elektrische Funktionen wie eine elektrische Beleuchtung, ein Verfahren der Verbundscheibe 100, beispielsweise das Öffnen oder Schließen einer Seitenscheibe in einer Fahrzeugtür, gesteuert werden können. Alternativ oder zusätzlich können ein oder mehrere kapazitive Schaltflächen 10 ein Tastenfeld bilden und mit einer Elektronik verknüpft, beispielsweise bei Eingabe einer definierten Tastreihenfolge, eine Fahrzeugtür öffnen oder verriegeln, eine Alarmanlage einschalten oder komplexe Steuerungen durchführen.

Wird die Verbundscheibe 100 beispielsweise als Dachscheibe in einem Kraftfahrzeug verwendet, kann die Länge des Zuleitungsbereichs 12 so gewählt werden, dass der Fahrer des Fahrzeugs, der Beifahrer oder Mitfahrer auf den hinteren Sitzplätzen den Berührungsbereich 11 des Schaltbereichs 10 bequem erreichen. Es versteht sich, dass dazu auch mehrere Trägerfolien 5 in der Verbundscheibe 100 angeordnet werden können, beispielsweise jeweils eine Trägerfolie 5 für jeden Fahrzeuginsassen.

Im dargestellten Ausgestaltungsbeispiel ist die Aufbau und die Abstimmung der Sensorelektronik 14 derart abgestimmt, dass bei Berührung der außenseitigen Scheibenoberfläche IV des Substrats 1 über dem Berührungsbereich 11 des kapazitiven Schaltbereichs 10 ein Schaltsignal ausgelöst wird, wobei bei Berührung der außenseitigen Scheibenoberfläche I der Deckscheibe 4 kein Schaltsignal ausgelöst wird. Dies hat den besonderen Vorteil, dass durch beabsichtigte oder versehentliche Berührung der Verbundscheibe 100 von außerhalb des Fahrzeugs kein Schaltsignal ausgelöst werden kann. Außerdem wird die versehentliche Auslösung eines Schaltsignals, beispielsweise durch Regen oder eine Waschanlage, vermieden. Dazu werden die Dicken und die Materialien der erfindungsgemäßen Verbundscheibe 100 erfindungsgemäß so gewählt, dass der Flächenkapazitätsbelag c_{I} zwischen dem Berührungsbereich 11 und der außenseitigen Oberfläche IV des Substrats 1 größer als der Flächenkapazitätsbelag c_{A} zwischen dem Berührungsbereich 11 und der außenseitigen Oberfläche I der Deckscheibe 4 ist. Des Weiteren ist es vorteilhaft, aber nicht notwendig, dass die kapazitive Schaltfläche 10 näher zum Substrat 1 angeordnet ist, als der Heizschaltkreis.

Die in Figur 2C dargestellte Querschnittsdarstellung entspricht einer Verbundscheibe 100 gemäß der aus Figur 2B, wobei lediglich die elektrisch leitfähige Schicht 6 auf derjenigen Seite der Trägerfolie 5 angeordnet, die dem Substrat 1 abgewandt ist.

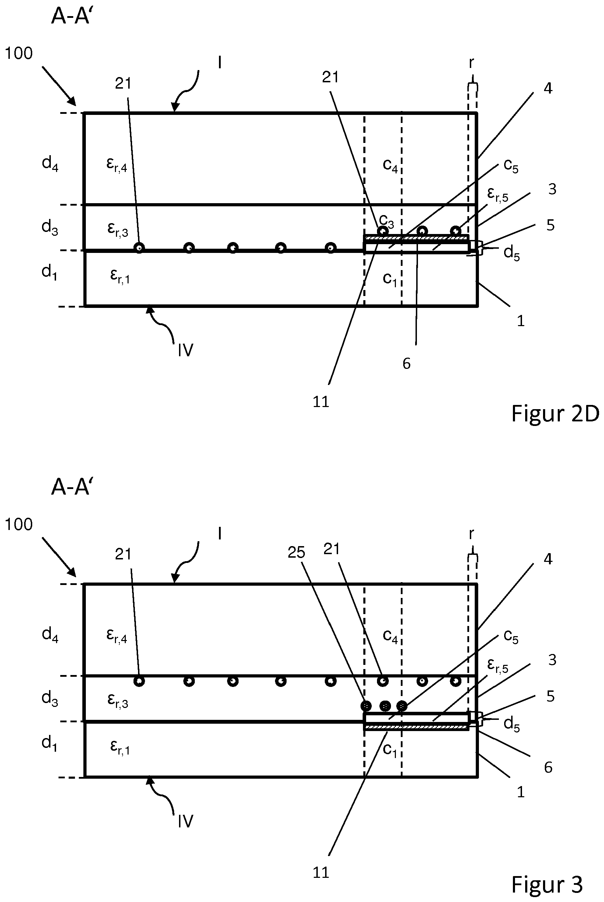

Die in Figur 2D dargestellte Querschnittsdarstellung entspricht in ihrer Ausgestaltung derjenigen aus Figur 2C, wobei die Heizdrähte 21 und die Stromsammelleiter 22 nicht zwischen der Deckscheibe 4 und der ersten Zwischenschicht 3 angeordnet sind, sondern zwischen dem Substrat 1 und der ersten Zwischenschicht 3. Die Heizdrähte sind hier unmittelbar benachbart zur elektrisch leitfähigen Schicht 6 angeordnet. Um elektrische Kurzschlüsse zu vermeiden, sind die Heizdrähte 21 durch eine polymere Ummantelung elektrisch isoliert. Wie Untersuchungen der Erfinder überraschenderweise ergaben, ist die Funktion der kapazitiven Schaltfläche durch räumliche Nähe zwischen elektrisch leitfähiger Schicht 6 und Heizdraht 21 nicht wesentlich beeinträchtigt. Dieses Ergebnis war für den Fachmann unerwartet und überraschend.

In einer vorteilhaften Ausgestaltung ist zumindest ein Heizdraht 21 zumindest in einem Teilbereich der Projektion der elektrisch leitfähigen Schicht 6 gebogen, gewunden, mäanderförmig, zick-zackförmig oder anderweitig verlängert ausgebildet. Dies hat den besonderen Vorteil, dass in diesem Abschnitt des Heizdrahts 21 die Verbundscheibe 100 verstärkt beheizbar ist. Dadurch kann die Position des kapazitiven Schaltbereichs 10 und insbesondere des Berührungsbereichs 11 besonders schnell enteist oder beschlagfrei gemacht werden und die Position des kapazitiven Schaltbereichs 10 ist für den Nutzer schnell und einfach erkennbar. Des Weiteren verstärkt sich durch diese Ausgestaltung die Asymmetrie der kapazitiven Schaltempfindlichkeit.

Figur 3 zeigt eine Weiterbildung einer erfindungsgemäßen Verbundscheibe 100 nach Figur 2B. In diesem Beispiel wurden in einem Bereich, der sich durch Projektion des Berührungsbereichs 11 auf die erste Zwischenschicht 3 ergibt, weitere Abschirmdrähte 25 zwischen Trägerfolie 5 und erster Zwischenschicht 3 eingelegt. Durch die Abschirmungsdrähte 25 verstärkt sich die Asymmetrie der kapazitiven Schaltempfindlichkeit, obwohl die Abschirmdrähte 25 weder mit dem Heizschaltkreis noch mit der Sensorelektronik 14 verbunden sein müssen. Die Abschirmdrähte 25 können dabei aus voneinander elektrisch isolierten Drahtabschnitten oder aus einem oder mehreren, beispielsweise gewundenen oder mäanderförmigen Drähten bestehen. Es versteht sich, dass die Abschirmdrähte 25 auch einseitig oder zweiseitig mit der Bezugsmasse oder mit den Heizdrähten 21 elektrisch verbunden sein können.

Es versteht sich, dass die Abschirmdrähte 25 auch in derselben Ebene wie die Heizdrähte 21 liegen können. Dazu können beispielsweise die Heizdrähten 21 zwischen dem Substrat 1 und der ersten Zwischenschicht 3 angeordnet sein, wie dies beispielsweise in Figur 2D gezeigt ist. Dies ist herstellungstechnisch besonders vorteilhaft und einfach zu realisieren.

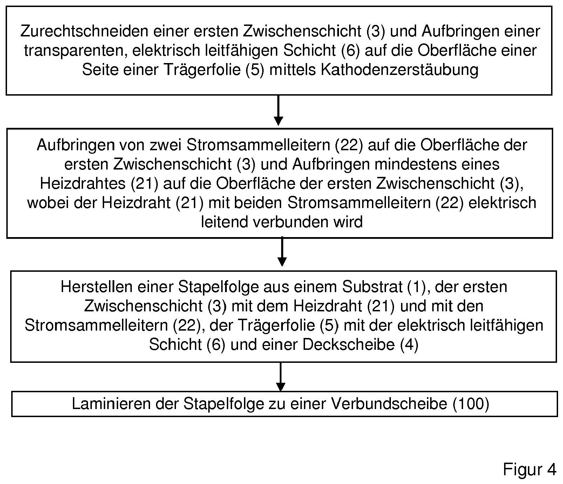

Figur 4 zeigt ein Flussdiagramm eines Ausführungsbeispiels des erfindungsgemäßen Verfahrens zur Herstellung einer Verbundscheibe 100 mit kapazitivem Schaltbereich 10.

### Bezugszeichenliste:

- 1: Substrat
- 2: zweite Zwischenschicht
- 3: erste Zwischenschicht
- 4: Deckscheibe
- 5: Trägerfolie
- 6: elektrisch leitfähige Schicht
- 7: Trennlinie
- 10: kapazitiver Schaltbereich
- 11: Berührungsbereich
- 12: Zuleitungsbereich
- 13: Anschlussbereich
- 14: kapazitive Sensorelektronik
- 15: Umgebungsbereich
- 16: weiterer Anschlussbereich
- 17: Folienleiter
- 18: beschichtungsfreier Randstreifen
- 20: elektrische Leitungsverbindung
- 21: Heizdraht
- 22: Stromsammelleiter
- 23: Zuleitung des Stromsammelleiters 22
- 24: Spannungsversorgung
- 25: Abschirmdraht
- 100: Verbundscheibe
- 101: Scheibenanordnung

- A: Fläche des Berührungsbereichs 11
- b_{A}: Breite des Anschlussbereichs 13
- b_{B}: Breite des Berührungsbereichs 11
- b_{Z}: Breite des Zuleitungsbereichs 12
- c_{I}, c_{A}, c_{1...5}: Flächenkapazitätsbelag
- C_{1...5}: Kapazität
- d₁,d₂,d₃,d₄,d₅: Dicke
- ε₀: elektrische Feldkonstante
- ε_{r,1}, ε_{r,2}, ε_{r,3}, ε_{r,4}, ε_{r,5}: relative Permittivität
- l_{A}: Länge des Anschlussbereichs 13
- l_{B}: Länge des Berührungsbereichs 11
- l_{Z}: Länge des Zuleitungsbereichs 12
- r: Randabstand
- t₁: Breite der Trennlinie 7
- A-A': Schnittlinie
- B-B': Schnittlinie
- I: außenseitige Oberfläche der Deckscheibe 4
- IV: außenseitigen Oberfläche des Substrats 1

## Patentansprüche

1. Scheibenanordnung (101), umfassend:
eine beheizbare Verbundscheibe (100) mit einem kapazitiven Schaltbereich (10), umfassend:
ein Substrat (1) und eine Deckscheibe (4) und mindestens eine erste Zwischenschicht (3), die zwischen dem Substrat (1) und der Deckscheibe (4) angeordnet ist, wobei
zwischen dem Substrat (1) und der ersten Zwischenschicht (3) oder zwischen der Deckscheibe (4) und der ersten Zwischenschicht (3) zumindest abschnittsweise eine Trägerfolie (5) mit einer elektrisch leitfähigen Schicht (6) angeordnet ist,
mindestens ein Bereich der elektrisch leitfähigen Schicht (6) einen kapazitiven Schaltbereich (10) bildet,
der kapazitive Schaltbereich (10) einen Berührungsbereich (11), einen Zuleitungsbereich (12) und einen Anschlussbereich (13) aufweist, der Zuleitungsbereich (12) den Berührungsbereich (11) mit dem Anschlussbereich (13) elektrisch verbindet und der Anschlussbereich (13) mit einer Sensorelektronik (14) elektrisch verbindbar ist und
mindestens ein Heizdraht (21) und mindestens zwei Stromsammelleiter (22) zwischen dem Substrat (1) und der Deckscheibe (4) angeordnet sind, und jeweils ein Ende des Heizdrahts (21) mit jeweils einem der Sammelleiter (22) elektrisch leitend verbunden ist, so dass bei Anlegen einer elektrischen Spannung an die Sammelleiter (22) ein Heizstrom durch den Heizdraht (21) fließen kann, wodurch der Heizdraht (21) beheizbar ist, und
eine kapazitive Sensorelektronik (14), **dadurch gekennzeichnet, dass** die kapazitive Sensorelektronik (14) über einen ersten Eingang mit dem Anschlussbereich (13) und über einen zweiten Eingang mit dem Heizdraht (21) oder den Stromsammelleitern (22) elektrisch leitend verbunden ist.

2. Scheibenanordnung (101) nach Anspruch 1, bei welcher der zweite Eingang der Sensorelektronik (14) mit einer elektrischen Masse verbunden ist.

3. Scheibenanordnung (101) nach Anspruch 1 oder 2, bei welcher der kapazitive Schaltbereich (10) in Projektion durch die Verbundscheibe (100) mit mindestens einem Heizdraht (21) überlappt.

4. Scheibenanordnung (101) nach einem der Ansprüche 1 bis 3, wobei der Heizdraht (21) und die Stromsammelleiter (22) zwischen der ersten Zwischenschicht (3) und der Deckscheibe (4) angeordnet sind.

5. Scheibenanordnung (101) nach einem der Ansprüche 1 bis 4, wobei ein minimaler Randabstand r der Trägerfolie (5) zu einer Seitenkante des Substrats (1) oder zu einer Seitenkante der Deckscheibe (4) größer oder gleich 5 mm, bevorzugt größer oder gleich 15 mm und insbesondere größer oder gleich 25 mm beträgt.

6. Scheibenanordnung (101) nach einem der Ansprüche 1 bis 5, wobei mindestens eine zweite Zwischenschicht (2) zwischen dem Substrat (1) und der Trägerfolie (5) mit der elektrisch leitfähigen Schicht (6) angeordnet ist.

7. Scheibenanordnung (101) nach einem der Ansprüche 1 bis 6, wobei der Heizdraht (22) ein Metall, bevorzugt Wolfram oder Kupfer enthält und eine elektrisch isolierende Ummantelung, bevorzugt aus einem Polymer, aufweist.

8. Scheibenanordnung (101) nach einem der Ansprüche 1 bis 7, wobei der Zuleitungsbereich (12) eine Länge l_{Z} von 1 cm bis 70 cm und bevorzugt von 1 cm bis 8 cm aufweist und eine Breite b_{Z} von 0,5 mm bis 10 mm und bevorzugt von 0,5 mm bis 2 mm aufweist und bevorzugt rechteckförmig, streifenförmig oder linienförmig ist und das Verhältnis von Länge l_{Z} zu Breite b_{Z} des Zuleitungsbereichs (12) bevorzugt kleiner oder gleich 1:700 und besonders bevorzugt von 1:5 bis 1:100 beträgt.

9. Scheibenanordnung (101) nach einem der Ansprüche 1 bis 8, wobei eine Fläche des Berührungsbereichs (11) von 1 cm² bis 200 cm², besonders bevorzugt von 1 cm² bis 9 cm² beträgt und/oder eine rechteckförmige, quadratische, trapezförmige, dreiecksförmige, kreisförmige, elliptische oder tropfenförmige Form oder abgerundete Ecken aufweist.

10. Scheibenanordnung (101) nach einem der Ansprüche 1 bis 9, wobei die erste Zwischenschicht (3) und/oder die zweite Zwischenschicht (2) transparent ist, Polyvinybutyral (PVB) enthält oder daraus besteht, und/oder eine relative Permittivität ε_{r,2/3} von 2 bis 4 und besonders bevorzugt von 2,1 bis 2,9 aufweist und die Trägerfolie (5) transparent ist, Polyethylenterephthalat (PET) enthält oder daraus besteht, und/oder eine relative Permittivität ε_{r,5} von 2 bis 4 und besonders bevorzugt von 2,7 bis 3,3 aufweist.

11. Scheibenanordnung (101) nach einem der Ansprüche 1 bis 10, wobei das Substrat (1) und/oder die Deckscheibe (4) Glas, bevorzugt Flachglas, Floatglas, Quarzglas, Borosilikatglas, Kalk-Natron-Glas, oder Polymere, bevorzugt Polyethylen, Polypropylen, Polycarbonat, Polymethylmethacrylat und/oder Gemische davon enthält, und/oder eine relative Permittivität ε_{r,1/4} von 2 bis 8 und besonders bevorzugt von 6 bis 8 aufweist.

12. Scheibenanordnung (101) nach einem der Ansprüche 1 bis 11, wobei die elektrisch leitfähige Schicht (2) transparent ist und/oder einen Flächenwiderstand von 0,4 Ohm/Quadrat bis 200 Ohm/Quadrat und bevorzugt von 0,5 Ohm/Quadrat bis 20 Ohm/Quadrat aufweist und/oder Silber (Ag), Indium-Zinnoxid (ITO), fluordotiertes Zinnoxid (SnO₂:F) oder aluminiumdotiertes Zinkoxid (ZnO:AI) enthält.

13. Scheibenanordnung (101) nach einem der Ansprüche 1 bis 12, wobei die Empfindlichkeit der Sensorelektronik (14) so gewählt ist, dass sie bei Berührung des Berührungsbereichs (11) mit einem menschlichen Finger auf einer äußeren Oberfläche (IV) des Substrats (1) ein Schaltsignal ausgibt und bei Berührung des Berührungsbereichs (11) auf einer äußeren Oberfläche (I) der Deckscheibe (4) kein Schaltsignal oder ein anderes Schaltsignal ausgibt.

14. Scheibenanordnung (101) nach einem der Ansprüche 1 bis 12, wobei die Empfindlichkeit der Sensorelektronik (14) so gewählt ist, dass sie bei Berührung des Berührungsbereichs (11) auf einer äußeren Oberfläche (IV) des Substrats (1) und/oder einer äußerener Oberfläche (I) der Deckscheibe (4) mit einem menschlichen Finger ein Schaltsignal ausgibt und bei Berührung des Zuleitungsbereichs (12) auf der Oberfläche (IV) des Substrats (1) und/oder der Oberfläche (I) der Deckscheibe (4) kein Schaltsignal oder ein anderes Schaltsignal ausgibt.

15. Verfahren zur Herstellung einer Scheibenanordnung (101) mit einer kapazitiven Verbundscheibe (100) mit kapazitivem Schaltbereich (10) nach einem der Ansprüche 1 bis 14, welches die folgenden Schritte umfasst:
(a) Zurechtschneiden einer ersten Zwischenschicht (3) und Aufbringen einer transparenten, elektrisch leitfähigen Schicht (6) auf die Oberfläche einer Seite einer Trägerfolie (5) mittels Kathodenzerstäubung,
(b) Aufbringen von zwei Stromsammelleitern (22) auf die Oberfläche der ersten Zwischenschicht (3) und Aufbringen mindestens eines Heizdrahtes (21) auf die Oberfläche der ersten Zwischenschicht (3), wobei der Heizdraht (21) mit beiden Stromsammelleitern (22) elektrisch leitend verbunden wird,
(c) Herstellen einer Stapelfolge aus einem Substrat (1), der ersten Zwischenschicht (3) mit dem Heizdraht (21) und den Stromsammelleitern (22), einer Trägerfolie (5) mit einer elektrisch leitfähigen Schicht (6) und einer Deckscheibe (4) und
(d) Laminieren der Stapelfolge zu einer Verbundscheibe (100).

16. Verwendung der Scheibenanordnung (101) mit einer kapazitiven Verbundscheibe (100) mit kapazitivem Schaltbereich (10) nach einem der Ansprüche 1 bis 14 in Fortbewegungsmitteln für den Verkehr auf dem Lande, in der Luft oder zu Wasser, insbesondere in Kraftfahrzeugen beispielsweise als Windschutzscheibe, Heckscheibe, Seitenscheiben und/oder Dachscheibe sowie als funktionales Einzelstück, und als Einbauteil in Möbeln, Geräten und Gebäuden, insbesondere als elektrischer Heizkörper.

## Claims

1. Pane arrangement (101), comprising:
a heatable composite pane (100) having a capacitive switching region (10), comprising:
a substrate (1) and a cover pane (4) and
at least one first intermediate layer (3), which is arranged between the substrate (1) and the cover pane (4), wherein
a carrier film (5) having an electrically conductive layer (6) is arranged between the substrate (1) and the first intermediate layer (3) or between the cover pane (4) and the first intermediate layer (3) at least in sections,
at least one region of the electrically conductive layer (6) forms a capacitive switching region (10),
the capacitive switching region (10) has a contact region (11), a supply line region (12), and a connection region (13), the supply line region (12) electrically connects the contact region (11) to the connection region (13) and the connection region (13) can be electrically connected to a sensor electronics system (14), and
at least one heating wire (21) and at least two busbars (22) are arranged between the substrate (1) and the cover pane (4), and in each case one end of the heating wire (21) is electrically conductingly connected to, in each case, one of the busbars (22), such that upon application of an electrical voltage to the busbars (22), a heating current can flow through the heating wire (21), whereby the heating wire (21) can be heated, and a capacitive sensor electronics system (14), **characterized in that** the capacitive sensor electronics system (14) is electrically conductingly connected to the connection region (13) via a first input and to the heating wire (21) or to the busbars (22) via a second input.

2. Pane arrangement (101) according to claim1, wherein the second input of the sensor electronics system (14) is connected to an electrical ground.

3. Pane arrangement (101) according to claim 1 or 2, wherein the capacitive switching region (10) in projection through the composite pane (100) overlaps with at least one heating wire (21).

4. Pane arrangement (101) according to one of claims 1 through 3, wherein the heating wire (21) and the busbars (22) are arranged between the first intermediate layer (3) and the cover pane (4).

5. Pane arrangement (101) according to one of claims 1 through 4, wherein a minimum distance from the edge r of the carrier film (5) from one side edge of the substrate (1) or from one side edge of the cover pane (4) is greater than or equal to 5 mm, preferably greater than or equal to 15 mm, and in particular greater than or equal to 25 mm.

6. Pane arrangement (101) according to one of claims 1 through 5, wherein at least one second intermediate layer (2) is arranged between the substrate (1) and the carrier film (5) with the electrically conductive layer (6).

7. Pane arrangement (101) according to one of claims 1 through 6, wherein the heating wire (21) includes a metal, preferably tungsten or copper and has an electrically insulating sheathing, preferably made of a polymer.

8. Pane arrangement (101) according to one of claims 1 through 7, wherein the supply line region (12) has a length l_{Z} of 1 cm to 70 cm and preferably of 1 cm to 8 cm and has a width bz of 0.5 mm to 10 mm and preferably of 0.5 mm to 2 mm and preferably has the shape of a rectangle, a strip, or a line, and the ratio of length l_{Z} to width bz of the supply line region (12) is preferably less than or equal to 1:700 and particularly preferably from 1:5 to 1:100.

9. Pane arrangement (101) according to one of claims 1 through 8, wherein an area of the contact region (11) is from 1 cm² to 200 cm², particularly preferably from 1 cm² to 9 cm², and/or has a rectangular, square, trapezoidal, triangular, circular, elliptical, or drop-shaped form or rounded corners.

10. Pane arrangement (101) according to one of claims 1 through 9, wherein the first intermediate layer (3) and/or the second intermediate layer (2) is transparent, contains or is made of polyvinyl butyral (PVB), and/or has a relative permittivity ε_{r,2/3} of 2 to 4 and particularly preferably of 2.1 to 2.9 and the carrier film (5) is transparent, contains or is made of polyethylene terephthalate (PET), and/or has a relative permittivity ε_{r,5} of 2 to 4 and particularly preferably of 2.7 to 3.3.

11. Pane arrangement (101) according to one of claims 1 through 10, wherein the substrate (1) and/or the cover pane (4) contains glass, preferably flat glass, float glass, quartz glass, borosilicate glass, soda lime glass, or polymers, preferably polyethylene, polypropylene, polycarbonate, polymethylmethacrylate, and/or mixtures thereof, and/or has a relative permittivity ε_{r,1/4} of 2 to 8 and particularly preferably of 6 to 8.

12. Pane arrangement (101) according to one of claims 1 through 11, wherein the electrically conductive layer (2) is transparent and/or has a sheet resistance of 0.4 ohm/square to 200 ohm/square and preferably of 0.5 ohm/square to 20 ohm/square and/or contains silver (Ag), indium tin oxide (ITO), fluorine-doped tin oxide (SnO₂:F), or aluminum doped zinc oxide (ZnO:AI).

13. Pane arrangement (101) according to one of claims 1 through 12, wherein the sensitivity of the sensor electronics system (14) is selected such that it outputs a switching signal upon contact of the contact region (11) with a human finger on an outer surface (IV) of the substrate (1) and outputs no switching signal or a different switching signal upon contact of the contact region (11) on an outer surface (I) of the cover pane (4).

14. Pane arrangement (101) according to one of claims 1 through 12, wherein the sensitivity of the sensor electronics system (14) is selected such that it outputs a switching signal upon contact of the contact region (11) on an outer surface (IV) of the substrate (1) and/or on an outer surface (I) of the cover pane (4) with a human finger and outputs no switching signal or a different switching signal upon contact of the supply line region (12) on the surface (IV) of the substrate (1) and/or on the surface (I) of the cover pane (4).

15. Method for producing a pane arrangement (101) having a capacitive composite pane (100) having a capacitive switching region (10) according to one of claims 1 through 14, which comprises the following steps:
(a) Cutting a first intermediate layer (3) to size and applying a transparent, electrically conductive layer (6) on the surface of one side of a carrier film (5) by cathodic sputtering,
(b) Applying two busbars (22) on the surface of the first intermediate layer (3) and applying at least one heating wire (21) on the surface of the first intermediate layer (3), wherein the heating wire (21) is electrically conductingly connected to both busbars (22),
(c) Producing a stack sequence of a substrate (1), the first intermediate layer (3) with the heating wire (21) and with the busbars (22), a carrier film (5) with an electrically conductive layer (6), and a cover pane (4), and
(d) Laminating the stack sequence to form a composite pane (100).

16. Use of the pane arrangement (101) having a capacitive composite pane (100) having a capacitive switching region (10) according to one of claims 1 through 14 in means of transportation for travel on land, in the air, or on water, in particular in motor vehicles, for example, as a windshield, rear window, side window, and/or roof panel as well as a functional individual piece, and as a built-in component in furniture, appliances, and buildings, in particular as an electric heater.

## Revendications

1. Arrangement des vitres (101), comprenant :
une vitre composite chauffante (100) ayant une zone de commutation capacitive (10), comprenant :
un substrat (1) et une vitre de recouvrement (4) et
au moins une première couche intermédiaire (3), qui est disposée entre le substrat (1) et la vitre de recouvrement (4), dans laquelle
un film porteur (5) avec une couche électriquement conductrice (6) est disposé entre le substrat (1) et la première couche intermédiaire (3) ou entre la vitre de recouvrement (4) et la première couche intermédiaire (3) au moins par sections,
au moins une région de la couche électriquement conductrice (6) forme une région de commutation capacitive (10),
la zone de commutation capacitive (10) comporte une zone de contact (11), une zone de ligne d'alimentation (12) et une zone de raccordement (13), la zone de ligne d'alimentation (12) relie électriquement la zone de contact (11) à la zone de raccordement (13) et la zone de raccordement (13) peut être reliée électriquement à une électronique de capteur (14), et
au moins un fil chauffant (21) et au moins deux barres omnibus (22) sont disposés entre le substrat (1) et la vitre de recouvrement (4), et une extrémité du fil chauffant (21) est reliée de manière électriquement conductrice à chacune des barres omnibus (22), de telle sorte que, lors de l'application d'une tension électrique aux barres omnibus (22), un courant de chauffage peut circuler à travers le fil de chauffage (21), le fil de chauffage (21) pouvant être chauffé, et une électronique de détection capacitive (14), **caractérisée en ce que** l'électronique de détection capacitive (14) est reliée de manière électriquement conductrice à la zone de raccordement (13) par une première entrée et au fil de chauffage (21) ou aux barres conductrices (22) par une deuxième entrée.

2. Agencement de vitres (101) selon la revendication 1, dans lequel la deuxième entrée de la électronique de détection (14) est reliée à une masse électrique.

3. Agencement de vitres (101) selon la revendication 1 ou 2, dans lequel la zone de commutation capacitive (10) en projection à travers la vitre composite (100) chevauche au moins un fil chauffant (21).

4. Agencement de vitres (101) selon l'une des revendications 1 à 3, dans lequel le fil chauffant (21) et les barres conductrices (22) sont disposés entre la première couche intermédiaire (3) et la vitre de recouvrement (4).

5. Agencement de vitres (101) selon l'une des revendications 1 à 4, dans lequel une distance minimale entre le bord r du film de support (5) et un bord latéral du substrat (1) ou un bord latéral de la vitre de recouvrement (4) est supérieure ou égale à 5 mm, de préférence supérieure ou égale à 15 mm, et en particulier supérieure ou égale à 25 mm.

6. Agencement de vitres (101) selon l'une des revendications 1 à 5, dans lequel au moins une deuxième couche intermédiaire (2) est disposée entre le substrat (1) et le film de support (5) avec la couche électriquement conductrice (6).

7. Agencement de vitres (101) selon l'une des revendications 1 à 6, dans lequel le fil chauffant (21) comprend un métal, de préférence du tungstène ou du cuivre, et présente une gaine électriquement isolante, de préférence en polymère.

8. Agencement de vitres (101) selon l'une des revendications 1 à 7, dans lequel la zone de conduite d'alimentation (12) a une longueur l_{Z} de 1 cm à 70 cm et de préférence de 1 cm à 8 cm et une largeur bz de 0,5 mm à 10 mm et de préférence de 0,5 mm à 2 mm et a de préférence la forme d'un rectangle, d'une bande ou d'une ligne, et le rapport entre la longueur l_{Z} et la largeur bz de la zone de conduite d'alimentation (12) est de préférence inférieur ou égal à 1:700 et particulièrement de préférence de 1:5 à 1:100.

9. Agencement de vitres (101) selon l'une des revendications 1 à 8, dans laquelle une surface de la zone de contact (11) est de 1 cm² à 200 cm², particulièrement préférablement de 1 cm² à 9 cm², et/ou présente une forme rectangulaire, carrée, trapézoïdale, triangulaire, circulaire, elliptique ou en goutte ou des coins arrondis.

10. Agencement de vitres (101) selon l'une des revendications 1 à 9, dans lequel la première couche intermédiaire (3) et/ou la deuxième couche intermédiaire (2) est transparente, contient ou est constituée de polyvinylbutyral (PVB), et/ou présente une permittivité relative ε_{r,2/3} de 2 à 4 et de manière particulièrement préférée de 2,1 à 2,9 et la feuille de support (5) est transparente, contient ou est constituée de polyéthylène téréphtalate (PET), et/ou présente une permittivité relative ε_{r,5} de 2 à 4 et de manière particulièrement préférée de 2,7 à 3,3.

11. Agencement de vitres (101) selon l'une des revendications 1 à 10, dans lequel le substrat (1) et/ou la vitre de recouvrement (4) contient du verre, de préférence du verre plat, du verre flotté, du verre de quartz, du verre borosilicaté, du verre sodocalcique ou des polymères, de préférence du polyéthylène, du polypropylène, du polycarbonate, du polyméthylméthacrylate et/ou des mélanges de ceux-ci, et/ou présente une permittivité relative εᵣ,1_{/4} de 2 à 8 et de manière particulièrement préférée de 6 à 8.

12. Agencement de vitres (101) selon l'une des revendications 1 à 11, dans lequel la couche électriquement conductrice (2) est transparente et/ou présente une résistance de feuille de 0,4 ohm/carré à 200 ohm/carré et de préférence de 0,5 ohm/carré à 20 ohm/carré et/ou contient de l'argent (Ag), de l'oxyde d'indium et d'étain (ITO), de l'oxyde d'étain dopé au fluor (SnO2:F) ou de l'oxyde de zinc dopé à l'aluminium (ZnO:Al).

13. Agencement de vitres (101) selon l'une des revendications 1 à 12, dans lequel la sensibilité du système électronique de détection (14) est choisie de telle sorte qu'il émet un signal de commutation lors du contact de la zone de contact (11) avec un doigt humain sur une surface extérieure (IV) du substrat (1) et n'émet aucun signal de commutation ou émet un signal de commutation différent lors du contact de la zone de contact (11) sur une surface extérieure (I) de la vitre de recouvrement (4).

14. Agencement de vitre (101) selon l'une des revendications 1 à 12, dans lequel la sensibilité du système électronique de capteur (14) est choisie de telle sorte qu'il émet un signal de commutation lors du contact de la zone de contact (11) avec un doigt humain sur une surface extérieure (IV) du substrat (1) et/ou sur une surface extérieure (I) de la vitre de recouvrement (4) et n'émet aucun signal de commutation ou émet un signal de commutation différent lors du contact de la zone de ligne d'alimentation (12) avec la surface (IV) du substrat (1) et/ou avec la surface (I) de la vitre de recouvrement (4).

15. Procédé de fabrication d'un agencement de vitres (101) avec une vitre composite capacitive (100) présentant une zone de commutation capacitive (10) selon l'une des revendications 1 à 14, qui comprend les étapes suivantes :
(a) découper 'une première couche intermédiaire (3) et application d'une couche transparente, électriquement conductrice (6) sur la surface d'un côté d'un film de support (5) par pulvérisation cathodique,
b) appliquer deux barres omnibus (22) sur la surface de la première couche intermédiaire (3) et application d'au moins un fil chauffant (21) sur la surface de la première couche intermédiaire (3), le fil chauffant (21) étant relié de manière conductrice de l'électricité aux deux barres omnibus (22),
(c) produire une séquence de piles d'un substrat (1), de la première couche intermédiaire (3) avec le fil chauffant (21) et avec les barres omnibus (22), d'un film porteur (5) avec une couche électriquement conductrice (6), et d'une vitre de recouvrement (4), et
(d) laminer la séquence de la pile pour former un vitrage composite (100).

16. Utilisation de l'agencement de vitres (101) avec une vitre composite capacitive (100) présentant une zone de commutation capacitive (10) selon l'une des revendications 1 à 14 dans des moyens de transport pour les déplacements sur terre, dans l'air ou sur l'eau, en particulier dans des véhicules automobiles, par exemple comme pare-brise, lunette arrière, fenêtre latérale et/ou toit ainsi que comme pièce individuelle fonctionnelle, et comme élément intégré dans des meubles, des appareils et des bâtiments, en particulier comme chauffage électrique.
